# EUROPEAN PATENT APPLICATION

(11) **EP 4 521 904 A1**
(43) Date of publication of application: **12.03.2025**
(21) Application number: 24195241.5
(22) Date of filing: 19.08.2024
(51) Int. Cl.: H10K 59/80, H10K 50/844

(54) **DISPLAY DEVICE AND METHOD OF FABRICATING THE SAME**

(30) Priority: 08.09.2023 KR 20230119590
(71) Applicant: Samsung Display Co., Ltd., Gyeonggi-do 17113 (KR)
(72) Inventor: HA, Jae Heung, Yongin-si (KR); KIM, Jong Woo, Yongin-si (KR); JUNG, Woo Suk, Yongin-si (KR)
(74) Representative: Marks & Clerk LLP

(57) **Abstract**

DISPLAY DEVICE AND METHOD OF FABRICATING THE SAME

A display device includes a substrate, a light emitting element layer on the substrate and including light emitting elements in a display area, and an encapsulation layer including a first inorganic encapsulation layer (141) on the light emitting element layer, an organic encapsulation layer (142) on the first inorganic encapsulation layer, and a second inorganic encapsulation layer (143) on the organic encapsulation layer, where the first inorganic encapsulation layer and/or the second inorganic encapsulation layer includes a first inorganic layer (IL1), a second inorganic layer (IL2) on the first inorganic layer and a third inorganic layer (IL3) on the second inorganic layer, a thickness of each of the first and third inorganic layers is less than a thickness of the second inorganic layer and is about 50 Å or less, and a ratio of the thickness of the first inorganic layer to the thickness of the second inorganic layer is about 0.03 or less.

## Description

### BACKGROUND

### 1. Field

The disclosure relates to a display device and a method of fabricating the display device.

### 2. Description of the Related Art

As the information society develops, demands for display devices for displaying images are increasing in various fields. For example, display devices are applied to various electronic devices such as smartphones, digital cameras, notebook computers, navigation devices, and smart televisions. The display devices may be flat panel display devices such as liquid crystal display devices, field emission display devices, and organic light emitting display devices. Among these flat panel display devices, a light emitting display device includes a light emitting element that enables each pixel of a display panel to emit light by itself. Thus, the light emitting display device can display an image without using a backlight unit that provides light to the display panel.

A display device may further include pixels that emit predetermined light, scan lines, data lines and power lines for driving the pixels, a scan driver that outputs scan signals to the scan lines, and a display driver that outputs data voltages to the data lines.

### SUMMARY

Embodiments of the disclosure provide a display device including a thin encapsulation layer and a method of fabricating the display device.

Embodiments of the disclosure also provide a display device including an encapsulation layer having specifications required as the display device becomes smaller and thinner and has flexible characteristics and a method of fabricating the display device.

However, features of embodiments of the disclosure are not restricted to the one set forth herein. The above and other features of embodiments of the disclosure will become more apparent to one of ordinary skill in the art to which the disclosure pertains by referencing the detailed description of the disclosure given below.

According to an embodiment of the disclosure, a display device includes a substrate on which a display area and a non-display area surrounding the display area are defined, a light emitting element layer disposed on the substrate and including a plurality of light emitting elements disposed in the display area, and an encapsulation layer including a first inorganic encapsulation layer disposed on the light emitting element layer, an organic encapsulation layer disposed on the first inorganic encapsulation layer, and a second inorganic encapsulation layer disposed on the organic encapsulation layer, where at least one selected from the first inorganic encapsulation layer and the second inorganic encapsulation layer includes a first inorganic layer, a second inorganic layer disposed on the first inorganic layer and a third inorganic layer disposed on the second inorganic layer, a thickness of each of the first inorganic layer and the third inorganic layer is less than a thickness of the second inorganic layer, the thickness of each of the first inorganic layer and the third inorganic layer is about 50 angstrom (Å) or less, and a ratio of the thickness of the first inorganic layer to the thickness of the second inorganic layer is about 0.03 or less.

In an embodiment, a sum of thicknesses of the first inorganic layer, the second inorganic layer, and the third inorganic layer may be about 0.4 micrometer (µm) or less.

In an embodiment, a layer density of the second inorganic layer may be in a range of about 1.7 gram per cubic centimeter (g/cm³) to about 2.10 g/cm³, a layer density of each of the first inorganic layer and the third inorganic layer may be about 2.05 g/cm³ or greater, and the layer density of each of the first inorganic layer and the third inorganic layer may be greater than the layer density of the second inorganic layer.

In an embodiment, a refractive index of the second inorganic layer may be in a range of about 1.75 to about 1.90, a refractive index of each of the first inorganic layer and the third inorganic layer may be about 1.85 or greater, and the refractive index of each of the first inorganic layer and the third inorganic layer may be greater than the refractive index of the second inorganic layer.

In an embodiment, each of the first inorganic layer, the second inorganic layer, and the third inorganic layer may include silicon nitride (SiNₓ).

In an embodiment, each of the first inorganic encapsulation layer and the second inorganic encapsulation layer may include the first inorganic layer, the second inorganic layer, and the third inorganic layer.

In an embodiment, the first inorganic encapsulation layer and the second inorganic encapsulation layer including the first inorganic layer, the second inorganic layer and the third inorganic layer may have a water vapor transmission rate (WVTR) of about 5×10⁻⁵ g/m²day or less.

In an embodiment, the second inorganic layer may have a WVTR of about 3×10⁻⁴ g/m²day or less.

In an embodiment, the display device may further include a first dam disposed in the non-display area and surrounding the display area and a second dam surrounding the first dam, where the organic encapsulation layer may be disposed in the display area and the non-display area inside the second dam.

In an embodiment, the first inorganic encapsulation layer and the second inorganic encapsulation layer may directly contact each other in the non-display area outside the second dam.

In an embodiment, side surfaces of the second inorganic layer may be exposed in the non-display area.

In an embodiment, the display device may further include a circuit layer disposed between the substrate and the light emitting element layer, where the circuit layer may include a first semiconductor layer, a first insulating layer, a first conductive layer, a second insulating layer, a second conductive layer, a third insulating layer, a second semiconductor layer, a fourth insulating layer, a third conductive layer, a fifth insulating layer, and a fourth conductive layer sequentially disposed on the substrate.

According to an embodiment of the disclosure, a method of fabricating a display device includes forming a light emitting element layer, which includes a plurality of light emitting elements, on a substrate, forming a first inorganic encapsulation layer on the light emitting element layer and forming an organic encapsulation layer on the first inorganic encapsulation layer, and forming a second inorganic encapsulation layer on the organic encapsulation layer, wherein the forming of the second inorganic encapsulation layer includes forming a first inorganic layer having a high-density on the organic encapsulation layer, forming a second inorganic layer having a low-density on the first inorganic layer, and forming a third inorganic layer having a high-density on the second inorganic layer, where a deposition rate in the forming of the second inorganic layer is higher than a deposition rate in the forming of the first inorganic layer and the forming of the third inorganic layer.

In an embodiment, the deposition rate in the forming of the second inorganic layer may be about 300 angstrom per minute (Å/min) or greater, and the deposition rate in each of the forming of the first inorganic layer and the forming of the third inorganic layer may be about 300 Å/min or less.

In an embodiment, a thickness of each of the first inorganic layer and the third inorganic layer may be less than a thickness of the second inorganic layer, the thickness of each of the first inorganic layer and the third inorganic layer may be about 50 Å or less, and a ratio of the thickness of the first inorganic layer to the thickness of the second inorganic layer may be about 0.03 or less.

In an embodiment, a layer density of the second inorganic layer may be in a range of about 1.7 g/cm³ to about 2.10 g/cm³, a layer density of each of the first inorganic layer and the third inorganic layer may be about 2.05 g/cm³ or greater and be greater than the layer density of the second inorganic layer, a refractive index of the second inorganic layer may be in a range of about 1.75 to about 1.90, a refractive index of each of the first inorganic layer and the third inorganic layer may be about 1.85 or greater, and the refractive index of each of the first inorganic layer and the third inorganic layer may be greater than the refractive index of the second inorganic layer.

In an embodiment, the forming of the first inorganic layer and the forming of the third inorganic layer may be each performed through a plasma enhanced atomic layer deposition (PEALD) process or a plasma enhanced chemical vapor deposition (PECVD) process, and the forming of the second inorganic layer may be performed through a PECVD process.

In an embodiment, the forming of the first inorganic layer and the forming of the third inorganic layer may be performed using a liquid precursor which includes a Si-N bond.

In an embodiment, the liquid precursor may include at least any one selected from cyclosilizane, trisilyamine, bis(diethylamino)silane, bis(t-butylamino)silane, tris(dimethylamino)silane, tris(isopropylamino)silane, tetrakis(dimethylamino)silane, tri(isopropyl)cyclotrisilazane, and tetramethyldisilazane.

In an embodiment, the second inorganic encapsulation layer including the first inorganic layer, the second inorganic layer and the third inorganic layer may have a WVTR of about 5×10⁻⁵ g/m²day or less, and the second inorganic layer may have a WVTR of about 3×10⁻⁴ g/m²day or less.

At least some of the above and other features of the invention are set out in the claims.

### BRIEF DESCRIPTION OF THE DRAWINGS

The above and other features of the invention will become more apparent by describing in further detail embodiments thereof with reference to the accompanying drawings, in which:
FIG. 1 is a perspective view of a display device according to an embodiment;
FIG. 2 is a plan view of the display device of FIG. 1;
FIG. 3 is a cross-sectional view taken along line A-A' of FIG. 2;
FIG. 4 is a plan view of a display panel according to an embodiment;
FIG. 5 is a pixel circuit diagram of a subpixel according to an embodiment;
FIG. 6 is a pixel circuit diagram of a subpixel according to an embodiment;
FIG. 7 is a cross-sectional view of a subpixel of the display device according to an embodiment;
FIG. 8 is a cross-sectional view of an outer portion of the display device according to an embodiment;
FIG. 9 is a schematic view of an encapsulation layer of the display device according to an embodiment;
FIG. 10 is an enlarged view of part C of FIG. 9;
FIG. 11 is an enlarged view of an inorganic bonding area in an outer portion of the display panel according to an embodiment;
FIG. 12 is a flowchart illustrating a method of fabricating a display device according to an embodiment;
FIG. 13 is a flowchart illustrating, in detail, a process of forming a second inorganic encapsulation layer in FIG. 12;
FIGS. 14 through 19 are views sequentially illustrating a process of fabricating a display device according to an embodiment;
FIG. 20 illustrates an encapsulation layer of a display device according to an embodiment;
FIG. 21 is an enlarged view of an inorganic bonding area in an outer portion of the display device of FIG. 20;
FIG. 22 is a perspective view of a head mounted display device according to an embodiment;
FIG. 23 is an exploded perspective view of an example of the head mounted display device of FIG. 22; and
FIG. 24 is a perspective view of a head mounted display device according to an embodiment.

### DETAILED DESCRIPTION

The invention will now be described more fully hereinafter with reference to the accompanying drawings, in which various embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the invention. Similarly, the second element could also be termed the first element.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments will be described with reference to the accompanying drawings.

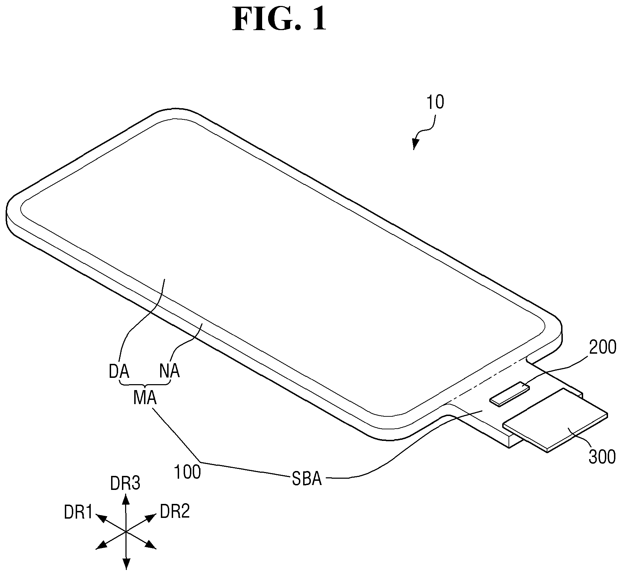

FIG. 1 is a perspective view of a display device 10 according to an embodiment.

Referring to FIG. 1, the display device 10 is a device for displaying moving images or still images. The display device 10 may be used as a display screen in portable electronic devices such as mobile phones, smartphones, tablet personal computers (PCs), smart watches, watch phones, mobile communication terminals, electronic notebooks, electronic books, portable multimedia players (PMPs), navigation devices and ultra-mobile PCs (UMPCs), as well as in various products such as televisions, notebook computers, monitors, billboards and Internet of things (IoT) devices.

The display device 10 may be a light emitting display device such as an organic light emitting display device including an organic light emitting diode, a quantum dot light emitting display device including a quantum dot light emitting layer, an inorganic light emitting display device including an inorganic semiconductor, or a micro- or nano-light emitting display device using a micro- or nano-light emitting diode. Hereinafter, for convenience of description, embodiments in which the display device 10 is an organic light emitting display device will be described, but the type of the display device is not limited thereto.

In an embodiment, the display device 10 may be formed flat. In an embodiment, for example, the display device 10 may be formed substantially flat on a plane defined by a first direction DR1 and a second direction DR2 and may have a predetermined thickness (or height) in a third direction DR3. In an embodiment, the display device 10 may include a curved portion in at least one part such as an edge area. In addition, the display device 10 may be formed to be flexible so that the display device 10 can be curved, bent, folded, or rolled.

In an embodiment, the first direction DR1 may be a lengthwise direction, a column direction or a vertical direction of an image display surface of the display device 10, and the second direction DR2 may be a direction intersecting the first direction DR1, for example, may be a widthwise direction, a row direction or a horizontal direction. The third direction DR3 may be a thickness direction or a height direction of the display device 10.

In an embodiment, the display device 10 may include a display panel 100, a driver 200, and a circuit board 300.

The display panel 100 may include a main area MA including a display area DA where an image is displayed and a sub-area SBA located at a side of the main area MA.

The main area MA may include the display area DA and a non-display area NA around the display area DA. The display area DA may be located in the center of the main area MA and may occupy most of the main area MA. The non-display area NA may be located at edges of the main area MA and may contact the sub-area SBA.

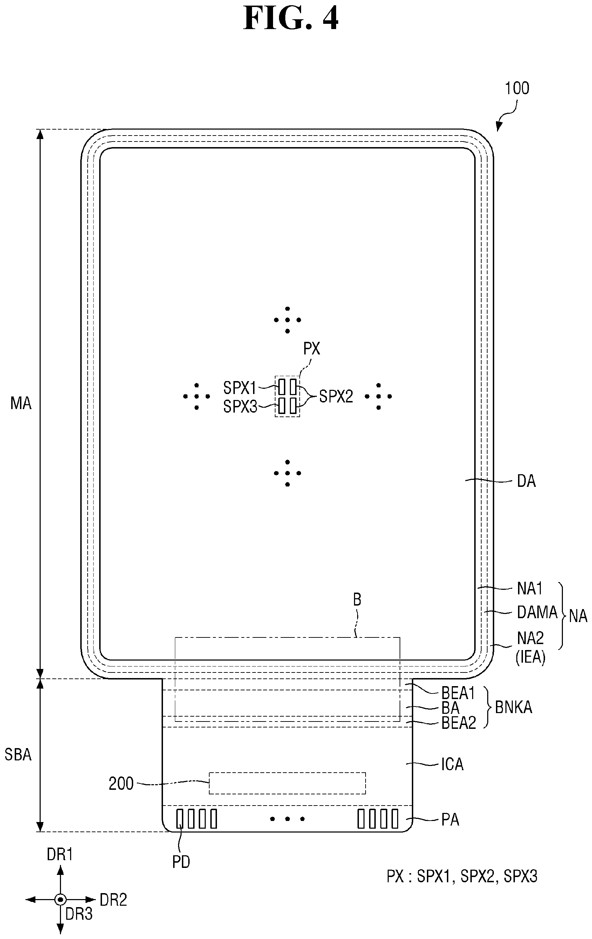

The display area DA may be an area where pixels (e.g., pixels PX of FIG. 4) are arranged and where an image is displayed by the pixels PX. In an embodiment, sensing patterns (e.g., touch electrodes) for detecting a touch input or the like may be further provided in the display area DA, and the display area DA may include a sensing area where a touch input is detected by the sensing patterns.

In an embodiment, the display area DA may be shaped like a substantially rectangular plane having long sides in the first direction DR1 and short sides in the second direction DR2. Each corner where a long side and a short side meet may be rounded or right-angled. The planar shape of the display area DA may vary according to embodiments. In an embodiment, for example, the display area DA may also have a polygonal shape other than a quadrangular shape, a circular shape, or an oval shape.

The non-display area NA may be located immediately around the display area DA. The non-display area NA may surround the display area DA. An embedded circuit may be disposed in the non-display area NA. In an embodiment, for example, an embedded circuit such as a scan driving circuit may be disposed in the non-display area NA on one side (e.g., a left or right side) or both sides of the display area DA.

The sub-area SBA may be located on a side of the main area MA. In an embodiment, for example, the sub-area SBA may be an area protruding from a side of the main area MA in the first direction DR1. In an embodiment, for example, the sub-area SBA may protrude from a lower end of the main area MA in the first direction DR1. In an embodiment, the sub-area SBA may be narrower than the main area MA. In an embodiment, for example, the sub-area SBA may be narrower than the main area MA in the second direction DR2.

Lines and pads may be disposed in the sub-area SBA. In an embodiment, for example, lines and pads connected to pixels and/or an embedded circuit located in the main area MA and the driver 200 and/or the circuit board 300 located in the sub-area SBA may be disposed in the sub-area SBA. In the description of embodiments, the term "connection" may mean physical connection and/or electrical connection.

In an embodiment, the driver 200 (e.g., a display driving circuit) may be mounted in the sub-area SBA. The circuit board 300 may be disposed on a portion of the sub-area SBA.

The driver 200 may include a data driving circuit for driving pixels. In an embodiment, the driver 200 may be formed as an integrated circuit (IC) chip and disposed in the sub-area SBA. In an embodiment, the driver 200 may be disposed on the circuit board 300 in the sub-area SBA or may be disposed on another circuit board connected to the display panel 100 through the circuit board 300.

The circuit board 300 may be disposed on a portion of the sub-area SBA. For example, the circuit board 300 may be bonded onto pads located in a portion (e.g., a lower edge) of the sub-area SBA and may supply or transmit power voltages and driving signals for driving the display panel 100 to the display panel 100. In an embodiment, for example, the circuit board 300 may supply input image data (e.g., digital image data), driving signals including timing signals, and driving voltages to the display panel 100. The circuit board 300 may be, but is not limited to, a flexible printed circuit board (FPCB), a printed circuit board (PCB), or a flexible film such as a chip on film (COF).

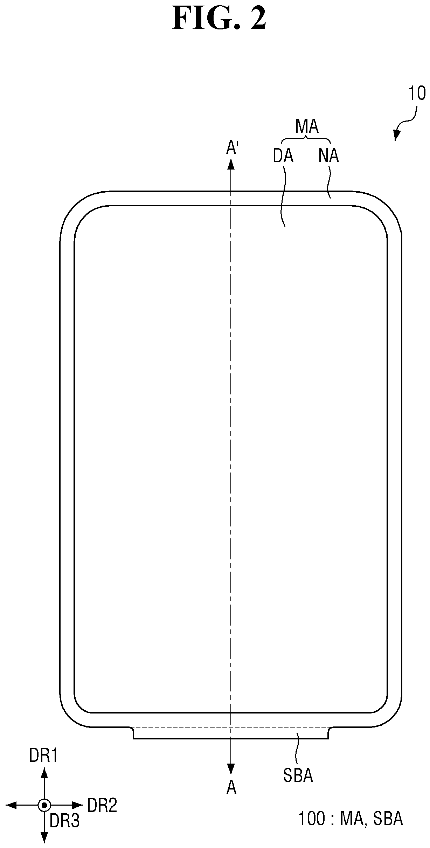

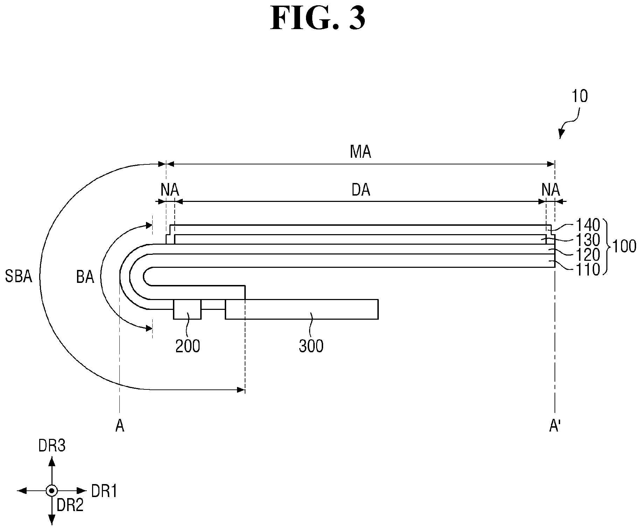

FIG. 2 is a plan view of the display device 10 of FIG. 1. FIG. 3 is a cross-sectional view taken along line A-A' of FIG. 2.

FIG. 1 illustrates the display device 10 in a state in which the display device 10 is unfolded without being bent, and FIGS. 2 and 3 illustrate the display device 10 in a state in which the display device 10 is bent in the sub-area SBA. FIG. 1 illustrates the display device 10 in a state in which the sub-area SBA is unfolded to lie side by side with the main area MA, and FIGS. 2 and 3 illustrate the display device 10 in a state in which a portion of the sub-area SBA is bent.

Referring to FIGS. 2 and 3, in an embodiment, the display panel 100 may include a substrate 110 including the main area MA and the sub-area SBA and a circuit layer 120, a light emitting element layer 130 and an encapsulation layer 140 sequentially stacked on the substrate 110. The circuit layer 120 may be located on the substrate 110 in the main area MA and sub-area SBA. The light emitting element layer 130 and the encapsulation layer 140 may be located on a portion of the substrate 110 and the circuit layer 120. In an embodiment, for example, the light emitting element layer 130 and the encapsulation layer 140 may be located in the main area MA.

In an embodiment, the display device 10 may further include additional elements disposed on the display panel 100. In an embodiment, for example, the display device 10 may further include at least one of a sensor layer (e.g., a touch sensor layer), a polarizing layer, a color filter layer, and a protective layer (e.g., a window) disposed on the encapsulation layer 140. Each of the sensor layer, the polarizing layer, the color filter layer, and/or the protective layer may be manufactured integrally with the display panel 100 or may be manufactured separately from the display panel 100 and then attached to the display panel 100 by an adhesive layer or the like.

The substrate 110 may include an insulating material such as polymer resin. For example, the substrate 110 may include or be made of polyimide or another insulating material. The substrate 110 may be a flexible substrate that can be bent, folded, or rolled. Alternatively, the substrate 110 may include an insulating material such as glass.

The circuit layer 120 may include pixel circuits and lines. In an embodiment, for example, the circuit layer 120 may include circuit elements (e.g., pixel transistors and a capacitor) constituting a pixel circuit of each pixel and lines connected to the pixels. In an embodiment, the circuit layer 120 may further include circuit elements constituting an embedded circuit, such as a scan driving circuit, and lines connected to the embedded circuit.

The light emitting element layer 130 may include light emitting elements disposed in emission areas of pixels. In an embodiment, for example, each of the pixels may include at least one light emitting element and a pixel circuit connected to the light emitting element. Each of the pixels may be located in a pixel area including an emission area where a light emitting element is disposed and a pixel circuit area where a pixel circuit is disposed. The emission area and pixel circuit area of each pixel may overlap each other, but the disclosure is not limited thereto.

In an embodiment, the circuit layer 120 and the light emitting element layer 130 may be separate from each other. However, the embodiments are not limited thereto. In an embodiment, for example, the circuit layer 120 and the light emitting element layer 130 may also be integrated.

The encapsulation layer 140 may cover the light emitting element layer 130 and extend to the non-display area NA to contact the circuit layer 120. In an embodiment, the encapsulation layer 140 may have a multilayer structure including at least two inorganic encapsulation layers overlapping each other and at least one organic encapsulation layer interposed between the inorganic encapsulation layers.

In an embodiment, the display panel 100 may be bent in a bending area BA. The bending area BA may be a portion of the sub-area SBA and may be spaced apart from the main area MA.

The substrate 110 and the circuit layer 120 may be bent in the bending area BA corresponding to a portion of the sub-area SBA. Accordingly, a bezel area perceived by a user as the non-display area NA can be reduced or minimized.

FIG. 4 is a plan view of a display panel 100 according to an embodiment. FIG. 4 illustrates the display panel 100 in an unfolded state without being bent.

Referring to FIG. 4, an embodiment of the display panel 100 may include the main area MA and the sub-area SBA. The main area MA may include the display area DA and the non-display area NA, and the sub-area SBA may include a bank area BNKA, a driving circuit mounting area ICA and a pad area PA.

The display area DA may be an area where a plurality of pixels PX are disposed. The pixels PX and lines (or portions of the lines) connected to the pixels PX may be disposed in the display area DA.

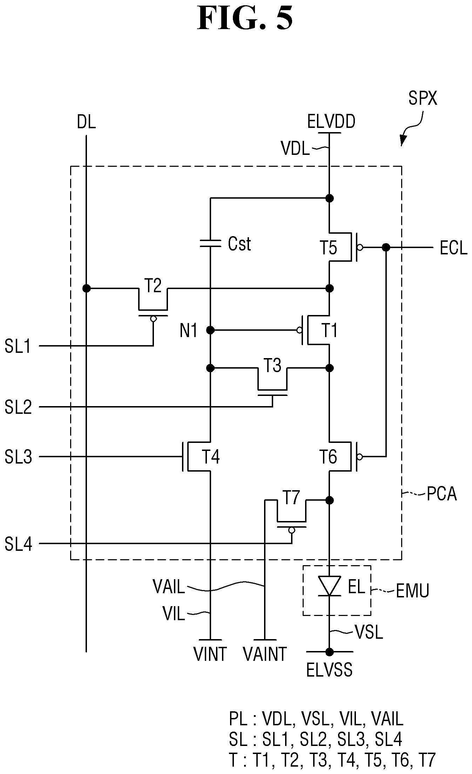

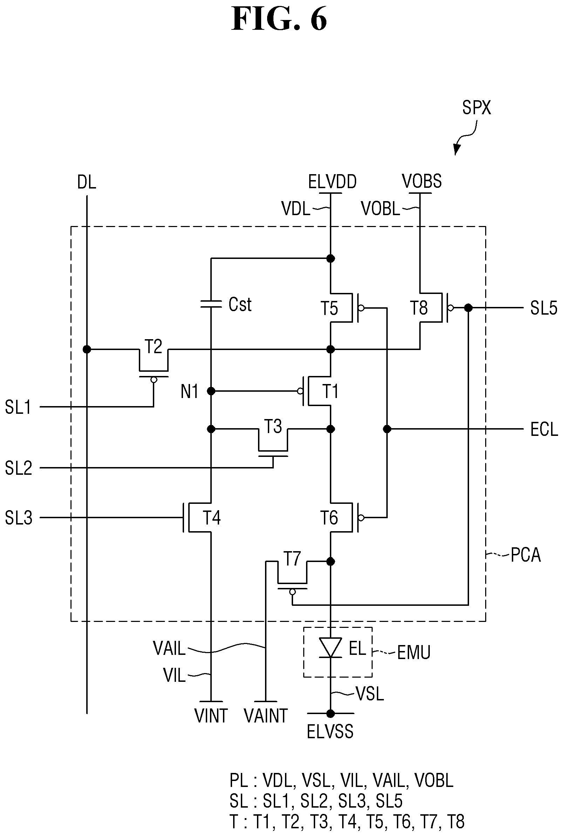

The pixels PX may be provided in the circuit layer 120 and the light emitting element layer 130 of the display panel 100. In an embodiment, for example, each of the pixels PX may include a pixel circuit (e.g., a pixel circuit PCA of FIG. 5 or 6) including circuit elements disposed in the circuit layer 120 and a light emitting element (e.g., a light emitting element EL of FIG. 5 or FIG. 6) disposed in the light emitting element layer 130.

The pixels PX may include at least two-color subpixels SPX that emit light of different colors, respectively. In an embodiment, for example, the pixels PX may include first-color subpixels SPX1 that emit light of a first color (e.g., red light), second-color subpixels SPX2 that emit light of a second color (e.g., green light), and third-color subpixels SPX3 that emit light of a third color (e.g., blue light).

At least one first-color subpixel SPX1, at least one second-color subpixel SPX2, and at least one third-color subpixel SPX3 adjacent to each other may form one unit pixel PX. In an embodiment, for example, one first-color subpixel SPX1, two second-color subpixels SPX2, and one third-color subpixel SPX3 adjacent to each other may form one unit pixel PX. Each unit pixel PX may emit light of various colors including white light by mixing the colors of light emitted from the subpixels SPX1 through SPX3 that form the unit pixel PX. In an embodiment, the first-color subpixels SPX1 and the third-color subpixels SPX3 may be arranged alternately in the first direction DR1 and/or the second direction DR2, and the second-color subpixels SPX2 may be arranged continuously and/or sequentially in the first direction DR1. The type, shape, and/or arrangement structure of the subpixels SPX1 through SPX3 may vary according to embodiments. In addition, the type, number, ratio, and/or arrangement structure of the subpixels SPX1 through SPX3 that form each unit pixel PX may vary according to embodiments.

The encapsulation layer 140 may be disposed on the pixels PX. In an embodiment, for example, the encapsulation layer 140 may be provided in at least the display area DA to cover the pixels PX, and a portion of the encapsulation layer 140 may extend to the non-display area NA.

Lines may be provided in the circuit layer 120 and located in the display area DA and the non-display area NA. In addition, the lines may be located in the sub-area SBA. In an embodiment, for example, the lines may extend from the sub-area SBA to the display area DA via the non-display area NA.

The non-display area NA may be located around the display area DA. In an embodiment, for example, the non-display area NA may be an edge area of the main area MA which is located outside the display area DA.

The non-display area NA may include a dam area DAMA spaced apart from the display area DA, a first non-display area NA1 between the display area DA and the dam area DAMA, and a second non-display area NA2 outside the dam area DAMA. The dam area DAMA may be an area where a dam surrounding the display area DA is disposed. The second non-display area NA2 may include an inorganic encapsulation area IEA (also referred to as a "bonding area") where inorganic encapsulation layers of the encapsulation layer 140 are bonded to each other.

The sub-area SBA may include the bank area BNKA, the driving circuit mounting area ICA, and the pad area PA sequentially defined or disposed on one side of the main area MA. Lines (or portions of the lines), a bank, and pads PD may be disposed in the sub-area SBA. At least some of the lines may extend to the main area MA and may be connected to the pixels PX.

The bank area BNKA may be an area where a bank including at least one organic layer is disposed. In an embodiment, the bank area BNKA may include the bending area BA. In an embodiment, for example, the bank area BNKA may include the bending area BA spaced apart from the main area MA and a first edge area BEA1 and a second edge area BEA2 located on both sides of the bending area BA in the first direction DR1. The bank may be provided in the bending area BA and areas around the bending area BA (e.g., the first edge area BEA1 and the second edge area BEA2 of the bank area BNKA) to cover lines passing through the bending area BA. The display panel 100 may be bent in the bending area BA so that a portion of the sub-area SBA is located on a rear surface of the main area MA.

The driving circuit mounting area ICA may be an area where the driver 200 is disposed. Pads for connecting at least some lines to the driver 200 may be disposed in the driving circuit mounting area ICA. In an embodiment, for example, input pads for connecting the driver 200 to certain pads (e.g., data input pads) of the pad area PA and output pads for connecting the driver 200 to the pixels PX may be disposed in the driving circuit mounting area ICA.

In some embodiments, the driver 200 may not be disposed on the display panel 100. In such embodiments, the display panel 100 may not include the driving circuit mounting area ICA, and only lines may be disposed in an area between the bank area BNKA and the pad area PA.

The pad area PA may be an area where the pads PD for connecting the display panel 100 and/or the driver 200 to the circuit board 300 or the like are disposed. The circuit board 300 may be disposed or bonded on the pad area PA.

A plurality of pads PD including power pads and signal pads connected to the pixels PX, the driver 200, and/or an embedded circuit may be disposed in the pad area PA. Power voltages for driving the pixels PX, the driver 200, and/or the embedded circuit may be supplied to the power pads. Driving signals and/or image data for driving the pixels PX, the driver 200, and/or the embedded circuit may be supplied to the signal pads. The type, location, arrangement order, and/or number of pads PD may vary according to embodiments.

FIG. 5 is a pixel circuit diagram of a subpixel SPX according to an embodiment. FIG. 6 is a pixel circuit diagram of a subpixel SPX according to an embodiment.

FIGS. 5 and 6 show various embodiments of a pixel circuit PCA and lines connected to the pixel circuit PCA. The configuration of the pixel circuit PCA and the type and number of lines connected to the pixel circuit PCA may vary according to embodiments.

FIG. 5 illustrates an embodiment in which each pixel circuit PCA includes first through seventh transistors T1 through T7. In an embodiment, scan lines SL connected to the subpixel SPX of FIG. 5 may include a first scan line SL1, a second scan line SL2, a third scan line SL3 and a fourth scan line SL4, and power lines PL connected to the subpixel SPX of FIG. 5 may include a first pixel power line VDL, a second pixel power line VSL, a first initialization power line VIL and a second initialization power line VAIL. The subpixel SPX of FIG. 5 may be further connected to an emission control line ECL.

FIG. 6 illustrates an embodiment in which each pixel circuit PCA includes first through eighth transistors T1 through T8. In an embodiment, scan lines SL connected to the subpixel SPX of FIG. 6 may include a first scan line SL1, a second scan line SL2, a third scan line SL3 and a fifth scan line SL5, and power lines PL connected to the subpixel SPX of FIG. 6 may include a first pixel power line VDL, a second pixel power line VSL, a first initialization power line VIL, a second initialization power line VAIL and a bias power line VOBL. The subpixel SPX of FIG. 6 may be further connected to an emission control line ECL.

Referring to FIG. 5, the subpixel SPX may include a light emitting unit EMU including at least one light emitting element EL and a pixel circuit PCA (also referred to as a "pixel driver") connected to the light emitting unit EMU.

The light emitting element EL may be connected between the second pixel power line VSL to which a second pixel power voltage ELVSS is applied and the pixel circuit PCA. In an embodiment, the second pixel power voltage ELVSS may be a low-potential pixel driving voltage. The light emitting element EL may be a light source of a pixel PX and may emit light in response to a driving current supplied from the pixel circuit PCA.

The light emitting element EL may be an organic light emitting diode. However, the disclosure is not limited thereto. In an embodiment, for example, the light emitting element EL may also be an inorganic light emitting element, a quantum dot light emitting element, or another type of light emitting elements.

The pixel circuit PCA may control the light emission timing and brightness of the light emitting element EL by controlling a driving current supplied to the light emitting element EL. The pixel circuit PCA may include at least one pixel transistor T and a capacitor Cst. In an embodiment, the pixel circuit PCA may include pixel transistors T including the first through seventh transistors T1 through T7.

The first transistor T1 may include a gate electrode connected to a first node N1, a first electrode electrically connected to the first pixel power line VDL through the fifth transistor T5, and a second electrode electrically connected to the light emitting unit EMU through the sixth transistor T6. One of the first electrode and the second electrode may be a source electrode, and the other of the first electrode and the second electrode may be a drain electrode. The first transistor T1 may control a source-drain current (hereinafter, referred to as a "driving current") flowing between the first electrode and the second electrode according to a voltage applied to the gate electrode (e.g., a voltage of the first node N1 corresponding to a voltage of a data signal). In such an embodiment, the first transistor T1 may be referred to as a driving transistor of the subpixel SPX.

The second transistor T2 may include a gate electrode connected to the first scan line SL1, a first electrode connected to a data line DL, and a second electrode connected to the first electrode of the first transistor T1. The second transistor T2 may be turned on by a first scan signal supplied to the first scan line SL1 to electrically connect the first electrode of the first transistor T1 to the data line DL. When the second transistor T2 is turned on, the voltage of a data signal supplied to the data line DL may be applied to the first electrode of the first transistor T1.

The third transistor T3 may include a gate electrode connected to the second scan line SL2, a first electrode connected to the second electrode of the first transistor T1, and a second electrode connected to the gate electrode of the first transistor T1 (or the first node N1). The third transistor T3 may be turned on by a second scan signal supplied to the second scan line SL2 to electrically connect the gate electrode and the second electrode of the first transistor T1. When the third transistor T3 is turned on, the first transistor T1 may operate as a diode.

The fourth transistor T4 may include a gate electrode connected to the third scan line SL3, a first electrode connected to the gate electrode of the first transistor T1, and a second electrode connected to the first initialization power line VIL. The fourth transistor T4 may be turned on by a third scan signal supplied to the third scan line SL3 to electrically connect the gate electrode of the first transistor T1 to the first initialization power line VIL. When the fourth transistor T4 is turned on, a first initialization voltage VINT (e.g., a gate initialization voltage) of the first initialization power line VIL may be applied to the gate electrode of the first transistor T1.

The fifth transistor T5 may include a gate electrode connected to the emission control line ECL, a first electrode connected to the first pixel power line VDL, and a second electrode connected to the first electrode of the first transistor T 1. The fifth transistor T5 may be turned on by an emission control signal supplied to the emission control line ECL to electrically connect the first electrode of the first transistor T1 to the first pixel power line VDL to which a first pixel power voltage ELVDD is applied. When the fifth transistor T5 is turned on, the first pixel power voltage ELVDD may be applied to the first electrode of the first transistor T1. In such an embodiment, the first pixel power voltage ELVDD may be referred to as a high-potential pixel driving voltage.

The sixth transistor T6 may include a gate electrode connected to the emission control line ECL, a first electrode connected to the second electrode of the first transistor T1, and a second electrode connected to the light emitting element EL. The sixth transistor T6 may be turned on by an emission control signal supplied to the emission control line ECL to electrically connect the first transistor T1 to the light emitting element EL. When both the fifth transistor T5 and the sixth transistor T6 are turned on, a driving current of a magnitude corresponding to the voltage of the gate electrode of the first transistor T1 may flow to the light emitting element EL.

The seventh transistor T7 may include a gate electrode connected to the fourth scan line SL4, a first electrode connected to an anode of the light emitting element EL, and a second electrode connected to the second initialization power line VAIL. The seventh transistor T7 may be turned on by a fourth scan signal supplied to the fourth scan line SL4 to electrically connect the anode of the light emitting element EL to the second initialization power line VAIL. The fourth scan signal may be the same signal or a different signal from the first scan signal. When the seventh transistor T7 is turned on, a second initialization voltage VAINT (e.g., an anode initialization voltage) of the second initialization power line VAIL may be applied to the anode of the light emitting element EL.

The capacitor Cst may be connected between the gate electrode of the first transistor T1 and the first pixel power line VDL. The capacitor Cst may be charged with a voltage corresponding to the voltage of a data signal applied to the gate electrode of the first transistor T1.

An active layer (e.g., a semiconductor pattern including a channel region) of each of the pixel transistors T (e.g., the first through seventh transistors T1 through T7) may include one semiconductor material selected from polysilicon, amorphous silicon, and an oxide semiconductor. In an embodiment, some of the pixel transistors T and the other pixel transistors T may be formed as transistors of different conductivity types. In addition, some of the pixel transistors T and the other pixel transistors T may include different types of semiconductor materials.

In an embodiment, for example, the first, second, fifth, sixth and seventh transistors T1, T2, T5, T6 and T7 may be formed as P-type transistors (e.g., P-type metal-oxide-semiconductor field-effect transistors (MOSFETs)), each including an active layer including or made of polysilicon, and the third and fourth transistors T3 and T4 may be formed as N-type transistors (e.g., N-type MOSFETs), each including an active layer including or made of an oxide semiconductor. In an embodiment, transistors, each including an active layer including or made of polysilicon, and transistors, each including an active layer including or made of an oxide semiconductor, may be disposed in different layers within the circuit layer 120.

Referring to FIG. 6 in addition to FIG. 5, the pixel circuit PCA may further include the eighth transistor T8. The eighth transistor T8 may include a gate electrode connected to the fifth scan line SL5, a first electrode connected to the bias power line VOBL, and a second electrode connected to a first electrode of the first transistor T1. The eighth transistor T8 may be turned on by a fifth scan signal supplied to the fifth scan line SL5 to electrically connect the first electrode of the first transistor T1 to the bias power line VOBL. When the eighth transistor T8 is turned on, a bias voltage VOBS supplied to the bias power line VOBL may be applied to the first electrode of the first transistor T1. In an embodiment, the bias voltage VOBS may have a voltage level suitable for compensating hysteresis characteristics of the first transistor T1. As the eighth transistor T8 is turned on, the first electrode of the first transistor T1 may be initialized to the bias voltage VOBS.

In the embodiment of FIG. 6, a gate electrode of the seventh transistor T7 may be connected to the fifth scan line SL5. Accordingly, the seventh transistor T7 may be turned on by the fifth scan signal supplied to the fifth scan line SL5 to connect an anode of a light emitting element EL to the second initialization power line VAIL.

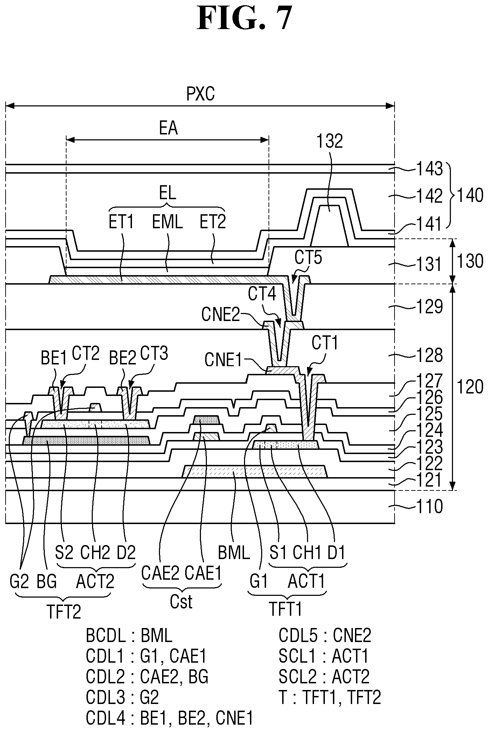

FIG. 7 is a cross-sectional view of a subpixel SPX of the display device 10 according to an embodiment. FIG. 7 is a cross-sectional view of a portion of an area corresponding to a subpixel SPX of the display area DA.

Referring to FIG. 7, the display panel 100 may include the substrate 110 and the circuit layer 120, the light emitting element layer 130 and the encapsulation layer 140 disposed on the substrate 110. The circuit layer 120, the light emitting element layer 130, and the encapsulation layer 140 may be sequentially disposed or stacked on the substrate 110 along the third direction DR3.

The substrate 110 may include or be made of a flexible material that can be bent, folded, or rolled. The substrate 110 may include or be made of an insulating material such as polymer resin. In an embodiment, for example, the substrate 110 may include or be made of polyimide.

The circuit layer 120 may include pixel circuits PXC and lines. In an embodiment, for example, the circuit layer 120 may include circuit elements (e.g., pixel transistors T and a capacitor Cst) constituting the pixel circuit PXC of each subpixel SPX and lines (e.g., various power lines and signal lines including power lines PL, scan lines SL, emission control lines ECL, and data lines DL) electrically connected to the subpixels SPX.

FIG. 7 illustrates a first thin-film transistor TFT1 (also referred to as a "first pixel transistor"), a second thin-film transistor TFT2 (also referred to as a "second pixel transistor"), and a capacitor Cst included in the pixel circuit PXC of each subpixel SPX among the elements that can be provided in the circuit layer 120. The first thin-film transistor TFT1 may be first-type transistors (e.g., P-type transistors) including a first semiconductor material (e.g., polysilicon) among the pixel transistors T constituting each pixel circuit PXC. In an embodiment, for example, the first thin-film transistor TFT1 may be one of the first, second, fifth, sixth, seventh, and/or eighth transistors T1, T2, T5, T6, T7, and/or T8. In FIG. 7, one transistor (e.g., the sixth transistor T6 of FIG. 5 or FIG. 6) connected to a light emitting element EL through at least one connection electrode (e.g., a first connection electrode CNE1 and a second connection electrode CNE2) among the first-type transistors is illustrated as an example of the first thin-film transistor TFT1. The second thin-film transistor TFT2 may be second-type transistors (e.g., N-type transistors) including a second semiconductor material (e.g., an oxide semiconductor) among the pixel transistors T. In an embodiment, for example, the second thin-film transistor TFT2 may be one of the third and fourth transistors T3 and T4.

The cross-sections of the subpixels SPX may vary according to the type and/or structure of each subpixel SPX and the display panel 100 including the subpixels SPX. In an embodiment, for example, the positions and formation order of the first thin-film transistor TFT1, the second thin-film transistor TFT2, and the capacitor Cst may vary according to embodiments.

The circuit layer 120 may include semiconductor layers and conductive layers for forming circuit elements and lines and insulating layers disposed between and/or around the conductive layers and the semiconductor layers. In an embodiment, for example, the circuit layer 120 may include a first semiconductor layer SCL1 (e.g., a polysilicon semiconductor layer), a first insulating layer 123 (e.g., a first gate insulating layer), a first conductive layer CDL1 (e.g., a first gate conductive layer), a second insulating layer 124 (e.g., a second gate insulating layer), a second conductive layer CDL2 (e.g., a second gate conductive layer), a third insulating layer 125 (e.g., a first interlayer insulating layer), a second semiconductor layer SCL2 (e.g., an oxide semiconductor layer), a fourth insulating layer 126 (e.g., a third gate insulating layer), a third conductive layer CDL3 (e.g., a third gate conductive layer), a fifth insulating layer 127 (e.g., a second interlayer insulating layer), a fourth conductive layer CDL4 (e.g., a first source-drain conductive layer), and a sixth insulating layer 128 (e.g., a first via layer or a first planarization layer) sequentially disposed on the substrate 110 in the third direction DR3. In an embodiment, the circuit layer 120 may further include a fifth conductive layer CDL5 (e.g., a second source-drain conductive layer) and a seventh insulating layer 129 (e.g., a second via layer or a second planarization layer) sequentially disposed on the sixth insulating layer 128. In an embodiment, the circuit layer 120 may further include a bottom conductive layer BCDL disposed between the substrate 110 and the first semiconductor layer SCL1, a barrier layer 121 disposed between the substrate 110 and the bottom conductive layer BCDL, and a buffer layer 122 disposed between the bottom conductive layer BCDL and the first semiconductor layer SCL1.

The barrier layer 121 may be disposed on the substrate 110. The barrier layer 121 may protect elements disposed in the circuit layer 120 and the light emitting element layer 130 from moisture introduced through the substrate 110 which is vulnerable to moisture penetration. The barrier layer 121 may include at least one inorganic layer including an inorganic insulating material (e.g., silicon nitride, silicon oxide, silicon oxynitride, titanium oxide, aluminium oxide, or other inorganic insulating materials). The material of the barrier layer 121 may vary according to embodiments.

The bottom conductive layer BCDL may be disposed on the barrier layer 121. The bottom conductive layer BCDL may include a bottom metal layer BML overlapping an active layer (e.g., a first active layer ACT1 and/or a second active layer ACT2) of at least one pixel transistor T and/or may include at least one line (or a portion of the at least one line). In an embodiment, as shown in FIG. 7, the bottom metal layer BML overlaps only the first active layer ACT1 of the first thin-film transistor TFT1 and capacitor electrodes CAE1 and CAE2 of the capacitor Cst, but the disclosure is limited thereto. In an embodiment, for example, the bottom metal layer BML may be patterned into an appropriate size and/or shape as needed and thus disposed in a portion of the pixel circuit PXC or may be disposed in the entire pixel circuit PXC. In an embodiment, for example, the bottom metal layer BML may be disposed only in a portion of a pixel area to overlap the first transistor T1 illustrated in FIGS. 5 and 6. In an embodiment, the bottom metal layer BML may be used as a light blocking pattern and/or a back-gate electrode of at least one pixel transistor T.

The buffer layer 122 may be disposed on the bottom conductive layer BCDL to cover the bottom conductive layer BCDL. The buffer layer 122 may include at least one inorganic layer including an inorganic insulating material.

The first thin-film transistor TFT1, the second thin-film transistor TFT2, and the capacitor Cst may be disposed on a surface of the substrate 110 including the buffer layer 122. The first thin-film transistor TFT1 may include the first active layer ACT1 and a first gate electrode G1. The second thin-film transistor TFT2 may include the second active layer ACT2 and a second gate electrode G2. In an embodiment, the second thin-film transistor TFT2 may include a back-gate electrode BG. The capacitor Cst may include a first capacitor electrode CAE1 and a second capacitor electrode CAE2.

The first semiconductor layer SCL1 may be disposed on the buffer layer 122. The first semiconductor layer SCL1 may include the first active layer ACT1 of the first thin-film transistor TFT1. In an embodiment, for example, the first semiconductor layer SCL1 may include the first active layer ACT1 of each of the first, second, fifth, sixth, seventh and/or eighth transistors T1, T2, T5, T6, T7, and T8.

The first active layer ACT1 may be provided in the first semiconductor layer SCL1 and may include a first semiconductor material (e.g., polysilicon). The first active layer ACT1 may include a first channel region CH1, a first source region S1, and a first drain region D1. The first channel region CH1 may overlap the first gate electrode G1 in the third direction DR3. The first source region S1 may be disposed on a side of the first channel region CH1, and the first drain region D1 may be disposed on the other side of the first channel region CH1. The first source region S1 and the first drain region D1 may be regions formed to have conductivity by doping a semiconductor for forming the first active layer ACT1 with ions or impurities. In an embodiment, the first source region S1 may be a source electrode of the first thin-film transistor TFT1. In an embodiment, the first thin-film transistor TFT1 may include a separate source electrode connected to the first source region S1. In an embodiment, the first drain region D1 may be a drain electrode of the first thin-film transistor TFT1. In an embodiment, the first thin-film transistor TFT1 may include a separate drain electrode connected to the first drain region D1.

The first insulating layer 123 may be disposed on the first semiconductor layer SCL1. The first insulating layer 123 may cover the first semiconductor layer SCL1.

The first conductive layer CDL1 may be disposed on the first insulating layer 123. The first conductive layer CDL1 may include the first gate electrode G1 of the first thin-film transistor TFT1. The first gate electrode G1 may overlap a portion of the first active layer ACT1 (e.g., the first channel region CH1). In an embodiment, the first conductive layer CDL1 may further include at least one line (or a portion of the at least one line), a metal pattern (e.g., a bridge pattern), and/or a capacitor electrode. For example, the first conductive layer CDL1 may further include the first capacitor electrode CAE1 of the capacitor Cst.

In an embodiment, the first capacitor electrode CAE1 may be formed integrally with the gate electrode of at least one first thin-film transistor TFT1 as a single unitary and indivisible part. In an embodiment, for example, the first capacitor electrode CAE1 may be formed integrally with the gate electrode of the first transistor T1 illustrated in FIGS. 5 and 6. In an embodiment, for example, the first capacitor electrode CAE1 and the gate electrode of the first transistor T1 may be formed as one conductive pattern, and the second capacitor electrode CAE2 may be disposed to overlap the conductive pattern.

The second insulating layer 124 may be disposed on the first conductive layer CDL1. The second insulating layer 124 may cover the first conductive layer CDL1.

The second conductive layer CDL2 may be disposed on the second insulating layer 124. The second conductive layer CDL2 may include one electrode of the capacitor Cst, for example, the second capacitor electrode CAE2. In an embodiment, the second conductive layer CDL2 may further include at least one electrode, at least one line (or a portion of the at least one line), and/or a metal pattern (e.g., a bridge pattern). In an embodiment, for example, the second conductive layer CDL2 may further include the back-gate electrode BG connected to the second gate electrode G2 of the second thin-film transistor TFT2.

The third insulating layer 125 may be disposed on the second conductive layer CDL2. The third insulating layer 125 may cover the second conductive layer CDL2.

The second semiconductor layer SCL2 may be disposed on the third insulating layer 125. The second semiconductor layer SCL2 may include the second active layer ACT2 of the second thin-film transistor TFT2. In an embodiment, for example, the second semiconductor layer SCL2 may include the second active layer ACT2 of each of the third and fourth transistors T3 and T4.

The second active layer ACT2 may be provided in the second semiconductor layer SCL2 and may include a second semiconductor material (e.g., an oxide semiconductor) different from the first semiconductor material. In an embodiment, for example, the second active layer ACT2 may include at last one selected from indium gallium zinc oxide (IGZO), indium gallium zinc tin oxide (IGZTO), or indium gallium tin oxide (IGTO).

The second active layer ACT2 may include a second channel region CH2, a second source region S2, and a second drain region D2. The second channel region CH2 may overlap the second gate electrode G2 in the third direction DR3. The second source region S2 may be disposed at a side of the second channel region CH2, and the second drain region D2 may be disposed at an opposing side of the second channel region CH2. The second source region S2 and the second drain region D2 may be regions formed to have conductivity by doping a semiconductor for forming the second active layer ACT2 with ions or impurities. In an embodiment, the second source region S2 may be a source electrode of the second thin-film transistor TFT2. In an embodiment, the second thin-film transistor TFT2 may include a separate source electrode connected to the second source region S2. In an embodiment, the second drain region D2 may be a drain electrode of the second thin-film transistor TFT2. In an embodiment, the second thin-film transistor TFT2 may include a separate drain electrode connected to the second drain region D2.

The fourth insulating layer 126 may be disposed on the second semiconductor layer SCL2. The fourth insulating layer 126 may cover the second semiconductor layer SCL2.

The third conductive layer CDL3 may be disposed on the fourth insulating layer 126. The third conductive layer CDL3 may include the second gate electrode G2 of the second thin-film transistor TFT2. The second gate electrode G2 may overlap a portion of the second active layer ACT2 (e.g., the second channel region CH2). In an embodiment, the third conductive layer CDL3 may further include at least one line (or a portion of the at least one line), a metal pattern (e.g., a bridge pattern), and/or a capacitor electrode.

In an embodiment, each of the electrodes, the conductive patterns, and/or the lines provided in the bottom conductive layer BCDL, the first conductive layer CDL1, the second conductive layer CDL2, and the third conductive layer CDL3 may include a conductive material (e.g., at least one selected from molybdenum (Mo), aluminium (Al), chromium (Cr), gold (Au), titanium (Ti), nickel (Ni), neodymium (Nd), copper (Cu) and other metals, an alloy thereof, or other conductive materials) and may have a single-layer or multilayer structure. In an embodiment, for example, the electrodes, the conductive patterns, and/or the lines provided in the bottom conductive layer BCDL, the first conductive layer CDL1, the second conductive layer CDL2, and the third conductive layer CDL3 may include molybdenum (Mo) or other metal materials. At least two selected from the bottom conductive layer BCDL, the first conductive layer CDL1, the second conductive layer CDL2, and the third conductive layer CDL3 may include a same material as each other or different materials from each other. The material of each of the bottom conductive layer BCDL, the first conductive layer CDL1, the second conductive layer CDL2, and the third conductive layer CDL3 is not limited and may vary according to embodiments.

The fifth insulating layer 127 may be disposed on the third conductive layer CDL3. The fifth insulating layer 127 may cover the third conductive layer CDL3.

In an embodiment, each of the first insulating layer 123, the second insulating layer 124, the third insulating layer 125, the fourth insulating layer 126, and the fifth insulating layer 127 may be an inorganic insulating layer including an inorganic insulating material (e.g., silicon nitride, silicon oxide, silicon oxynitride, titanium oxide, aluminium oxide, or other inorganic insulating materials) and may have a single-layer or multilayer structure. At least two selected from the first insulating layer 123, the second insulating layer 124, the third insulating layer 125, the fourth insulating layer 126, and the fifth insulating layer 127 may include a same material as each other or different materials from each other. The material of each of the first insulating layer 123, the second insulating layer 124, the third insulating layer 125, the fourth insulating layer 126, and the fifth insulating layer 127 may vary according to embodiments.

The fourth conductive layer CDL4 may be disposed on the fifth insulating layer 127. The fourth conductive layer CDL4 may include the first connection electrode CNE1 (or the drain electrode of the first thin-film transistor TFT 1), a first bridge electrode BE1 (or the source electrode of the second thin-film transistor TFT2), and a second bridge electrode BE2 (or the drain electrode of the second thin-film transistor TFT2). The first connection electrode CNE1 may be provided in the fourth conductive layer CDL4 and connected to the first drain region D1 of the first active layer ACT1 through a first contact hole CT1 defined through the first insulating layer 123, the second insulating layer 124, the third insulating layer 125, the fourth insulating layer 126, and the fifth insulating layer 127. The first bridge electrode BE1 may be provided in the fourth conductive layer CDL4 and connected to the second source region S2 of the second active layer ACT2 through a second contact hole CT2 defined through the fourth insulating layer 126 and the fifth insulating layer 127. The second bridge electrode BE2 may be connected to the second drain region D2 of the second active layer ACT2 through a third contact hole CT3 defined through the fourth insulating layer 126 and the fifth insulating layer 127. In an embodiment, the fourth conductive layer CDL4 may further include at least one line (or a portion of the at least one line) and/or a metal pattern (e.g., a bridge pattern). In an embodiment, for example, the fourth conductive layer CDL4 may include a portion of a power line PL (e.g., the first pixel power line VDL and/or the second pixel power line VSL) provided inside and/or outside the display area DA.

The sixth insulating layer 128 may be disposed on the fourth conductive layer CDL4. The sixth insulating layer 128 may cover the fourth conductive layer CDL4.

The fifth conductive layer CDL5 may be disposed on the sixth insulating layer 128. The fifth conductive layer CDL5 may include the second connection electrode CNE2. The second connection electrode CNE2 may be provided in the fifth conductive layer CDL5 and connected to the first connection electrode CNE1 through a fourth contact hole CT4 (or a first via hole) defined through the sixth insulating layer 128. In an embodiment, the fifth conductive layer CDL5 may further include at least one line (or a portion of the at least one line) and/or a metal pattern (e.g., a bridge pattern). In an embodiment, for example, the fifth conductive layer CDL5 may include a portion of a power line PL (e.g., the first pixel power line VDL and/or the second pixel power line VSL) provided inside and/or outside the display area DA.

In an embodiment, each of the electrodes, the conductive patterns, and/or the lines provided in the fourth conductive layer CDL4 and the fifth conductive layer CDL5 may include a conductive material (e.g., at least one of molybdenum (Mo), aluminium (Al), chromium (Cr), gold (Au), titanium (Ti), nickel (Ni), neodymium (Nd), copper (Cu) and other metals, an alloy thereof, or other conductive materials) and may have a single-layer or multilayer structure. For example, each of the electrodes, the conductive patterns, and/or the lines provided in the fourth conductive layer CDL4 and the fifth conductive layer CDL5 may have a triple-layer structure of titanium/aluminium/titanium (Ti/Al/Ti). The fourth conductive layer CDL4 and the fifth conductive layer CDL5 may include the same material or different materials. The material of each of the fourth conductive layer CDL4 and the fifth conductive layer CDL5 may vary according to embodiments.

The seventh insulating layer 129 may be disposed on the fifth conductive layer CDL5. The seventh insulating layer 129 may cover the fifth conductive layer CDL5.

In an embodiment, each of the sixth insulating layer 128 and the seventh insulating layer 129 may be an organic insulating layer including an organic insulating material (e.g., acryl resin, epoxy resin, phenolic resin, polyamide resin, polyimide resin, or other organic insulating materials) to planarize the circuit layer 120 and may have a single-layer or multilayer structure. The sixth insulating layer 128 and the seventh insulating layer 129 may include the same material or different materials. The material of each of the sixth insulating layer 128 and the seventh insulating layer 129 may vary according to embodiments.

The light emitting element layer 130 may include a pixel defining layer 131 separating emission areas EA of the pixels PX and light emitting elements EL respectively located in the emission areas EA. In an embodiment, the light emitting element layer 130 may further include a spacer 132 disposed on a portion of the pixel defining layer 131.

Each light emitting element EL may include a first electrode ET1 (e.g., an anode) connected to at least one transistor T (e.g., the first thin-film transistor TFT1) included in a corresponding subpixel SPX through the first connection electrode CNE1 and/or the second connection electrode CNE2 and a light emitting layer EML and a second electrode ET2 (e.g., a cathode) sequentially disposed on the first electrode ET1. In an embodiment, each light emitting element EL may further include a first intermediate layer (e.g., a hole layer including a hole transport layer) interposed between the first electrode ET1 and the light emitting layer EML and a second intermediate layer (e.g., an electron layer including an electron transport layer) interposed between the light emitting layer EML and the second electrode ET2.

The first electrode ET1 of each light emitting element EL may include a conductive material and may be disposed on the circuit layer 120. In an embodiment, for example, the first electrode ET1 may be disposed on the seventh insulating layer 129 in each emission area EA. The first electrode ET1 may be connected to the second connection electrode CNE2 through a fifth contact hole CT5 (or a second via hole) defined through the seventh insulating layer 129. In an embodiment, the first electrode ET1 may include a metal material having high reflectivity. In an embodiment, for example, the first electrode ET1 may have a single-layer structure of molybdenum (Mo), titanium (Ti), copper (Cu) or aluminium (Al) or may have a multilayer structure (e.g., ITO/Mg, ITO/MgF, ITO/Ag, or ITO/Ag/ITO) including indium-tin-oxide (ITO), indium-zinc-oxide (IZO), zinc oxide (ZnO), indium oxide (In₂O₃), silver (Ag), magnesium (Mg), aluminium (Al), platinum (Pt), lead (Pb), gold (Au) or nickel (Ni).

The light emitting layer EML of each light emitting element EL may include a high molecular weight material or a low molecular weight material. In an embodiment, the light emitting layer EML may be provided for each subpixel SPX, and the light emitting layer EML of each subpixel SPX may emit visible light of a color corresponding to the subpixel SPX. In an embodiment, the light emitting layer EML may be a common layer shared by subpixels SPX of different colors, and a wavelength conversion layer and/or a color filter corresponding to a color (or wavelength band) of light to be emitted from each subpixel SPX may be disposed in the emission areas EA of at least some of the subpixels SPX.

The second electrode ET2 of each light emitting element EL may include a conductive material and may be connected to the second pixel power line VSL. In an embodiment, the second electrode ET2 may be a common layer formed over the entire display area DA to cover the light emitting layers EML and the pixel defining layer 131. In an embodiment, the second electrode ET2 may include or be made of a transparent conductive material (TCO) that can transmit light, such as ITO or IZO, or a semi-transmissive conductive material such as magnesium (Mg), silver (Ag) or an alloy of Mg and Ag. In an embodiment where the second electrode ET2 includes or is made of a semi-transmissive conductive material, an improvement in light output efficiency by a microcavity effect can be expected.

The pixel defining layer 131 may define openings corresponding to the emission areas EA, respectively, and may surround the emission areas EA. In an embodiment, for example, the pixel defining layer 131 may be formed to cover edges of the first electrode ET1 of each light emitting element EL and may define an opening exposing the other portion of the first electrode ET1. An area where the exposed first electrode ET1 and the light emitting layer EML overlap (or an area including the exposed first electrode ET1 and the light emitting layer EML) may be defined as the emission area EA of each pixel PX.

In an embodiment, the pixel defining layer 131 may include at least one organic layer including an organic insulating material. In an embodiment, for example, the pixel defining layer 131 may include polyacrylates resin, epoxy resin, phenolic resin, polyamides resin, polyimides resin, unsaturated polyesters resin, polyphenylenethers resin, polyphenylenesulfides resin or benzocyclobutene (BCB) or may include other organic insulating materials.

The spacer 132 may be disposed on a portion of the pixel defining layer 131. The spacer 132 may include at least one organic layer including an organic insulating material. The spacer 132 may include the same material as the pixel defining layer 131 or may include a different material from the pixel defining layer 131. In an embodiment, the pixel defining layer 131 and the spacer 132 may be sequentially formed through respective mask processes. In an embodiment, the pixel defining layer 131 and the spacer 132 may be simultaneously formed using a halftone mask. In this case, the pixel defining layer 131 and the spacer 132 may be considered as one integrated insulating layer. The organic insulating material that forms the spacer 132 is not particularly limited and may vary according to embodiments.

The encapsulation layer 140 may be disposed on the light emitting element layer 130 in the main area MA. In an embodiment, for example, the encapsulation layer 140 may be disposed in the display area DA and the non-display area NA to cover the light emitting element layer 130. The encapsulation layer 140 may block penetration of oxygen or moisture into the light emitting element layer 130 and reduce electrical or physical shock to the circuit layer 120 and the light emitting element layer 130.

In an embodiment, the encapsulation layer 140 may include a first inorganic encapsulation layer 141, an organic encapsulation layer 142, and a second inorganic encapsulation layer 143 sequentially disposed on the light emitting element layer 130. The first inorganic encapsulation layer 141 and the second inorganic encapsulation layer 143 may include an inorganic material, and the organic encapsulation layer 142 may include an organic material.

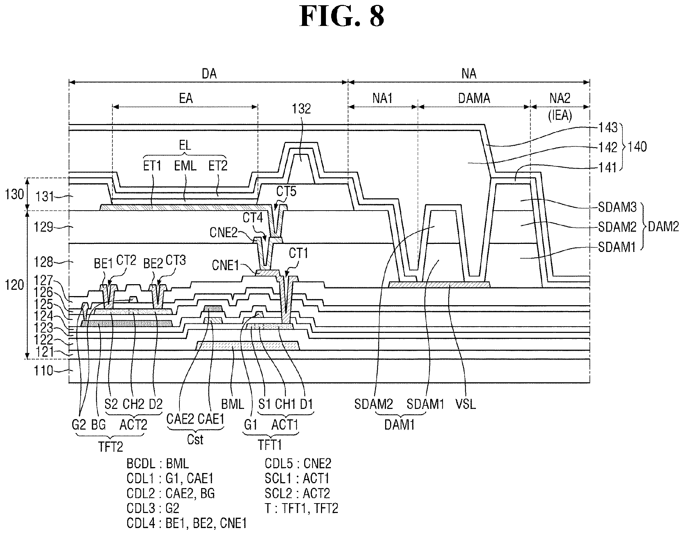

FIG. 8 is a cross-sectional view of an outer portion of the display panel 100 according to an embodiment. FIG. 8 illustrates a portion of the display area DA and a portion of the non-display area NA of the display panel 100.

Referring to FIG. 8, the display panel 100 may include a plurality of dam structures DAM1 and DAM2 disposed in the dam area DAMA of the non-display area NA. The dam structures DAM1 and DAM2 may surround the display area DA of the display panel 100 in a plan view. In an embodiment, for example, the dam structures DAM1 and DAM2 may include a first dam DAM1 surrounding the display area DA and a second dam DAM2 surrounding the first dam DAM1. The second dam DAM2 may be disposed closer to edges of the display panel 100 than the first dam DAM1. The display panel 100 including the dam structures DAM1 and DAM2 may effectively prevent an organic material of the organic encapsulation layer 142 of the encapsulation layer 140 from overflowing.

In an embodiment, each of the first dam DAM1 and the second dam DAM2 may include a plurality of sub-dams SDAM1 through SDAM3. In an embodiment, the sub-dams SDAM1 through SDAM3 may respectively include a same material as a plurality of organic material layers disposed in the display area DA and may be formed through a same process as the organic material layers. In an embodiment, the sub-dams SDAM1 through SDAM3 may respectively be disposed in (or directly on) a same layer as a plurality of organic material layers disposed in the display area DA.

In an embodiment, for example, each of the first dam DAM1 and the second dam DAM2 may include a first sub-dam SDAM1 and a second sub-dam SDAM2 disposed on the first sub-dam SDAM1. The second dam DAM2 may further include a third sub-dam SDAM3 disposed on the second sub-dam SDAM2. The first sub-dam SDAM1 may include a same material as the sixth insulating layer 128 and may be formed in or (directly on) substantially the same layer as the sixth insulating layer 128. The second sub-dam SDAM2 may include a same material as the seventh insulating layer 129 and may be formed in or (directly on) substantially the same layer as the seventh insulating layer 129. The third sub-dam SDAM3 may include a same material as the pixel defining layer 131 and/or the spacer 132 and may be formed in or (directly on) substantially the same layer as the pixel defining layer 131 and/or the spacer 132. The first sub-dam SDAM1, the second sub-dam SDAM2, and the third sub-dam SDAM3 may be respectively considered as portions of the sixth insulating layer 128, the seventh insulating layer 129, and the pixel defining layer 131 and/or the spacer 132 disposed in the display area DA.

Since the first dam DAM1 and the second dam DAM2 are spaced apart from the display area DA, a valley may be formed between the dam area DAMA and the display area DA and/or between adjacent dams DAM. The organic encapsulation layer 142 may be effectively prevented from overflowing to the edges of the display panel 100 by the valley. The organic encapsulation layer 142 may fill the valley between the first dam DAM1 and the display area DA.

The first inorganic encapsulation layer 141, the organic encapsulation layer 142, and the second inorganic encapsulation layer 143 of the encapsulation layer 140 may be disposed in the first non-display area NA1 between the first dam DAM1 and the display area DA and in the dam area DAMA of the non-display area NA. Since the organic encapsulation layer 142 does not extend beyond at least the second dam DAM2, the organic encapsulation layer 142 may not be disposed in the second non-display area NA2 between the second dam DAM2 and the edges in the non-display area NA, and the first inorganic encapsulation layer 141 and the second inorganic encapsulation layer 143 of the encapsulation layer 140 may contact each other in the second non-display area NA2. The second non-display area NA2 where the first inorganic encapsulation layer 141 and the second inorganic encapsulation layer 143 contact each other may be the inorganic encapsulation area IEA. The inorganic encapsulation area IEA where the first inorganic encapsulation layer 141 and the second inorganic encapsulation layer 143 contact each other may be formed outside the second dam DAM2, thereby blocking a path through which moisture penetration from the outside may occur.

In an embodiment, the encapsulation layer 140 may include the organic encapsulation layer 142 between two different inorganic encapsulation layers 141 and 143 as described above, but the disclosure is not limited thereto. In some embodiments, the organic encapsulation layer 142 may be omitted, and the encapsulation layer 140 may have a structure in which one or more inorganic encapsulation layers are stacked.

The display panel 100 may include the second pixel power line VSL disposed in the non-display area NA. The second pixel power line VSL may overlap the first dam DAM1 and may surround the display area DA. A portion of the second pixel power line VSL may not overlap the first dam DAM1 and may contact the second electrode ET2 of a light emitting element EL in the valley disposed between the first dam DAM1 and the display area DA. The second electrode ET2 of the light emitting element EL may receive a second power voltage from the second pixel power line VSL.

In an embodiment, the first dam DAM1 and the second dam DAM2 are disposed on the second pixel power line VSL as shown in FIG. 8, but the disclosure is not limited thereto. In an embodiment, for example, any one of the first dam DAM1 and the second dam DAM2 may not be disposed on the second pixel power line VSL. Alternatively, neither the first dam DAM1 nor the second dam DAM2 may be disposed on the second pixel power line VSL. In such an embodiment, the first dam DAM1 and the second dam DAM2 may be disposed outside the second pixel power line VSL.

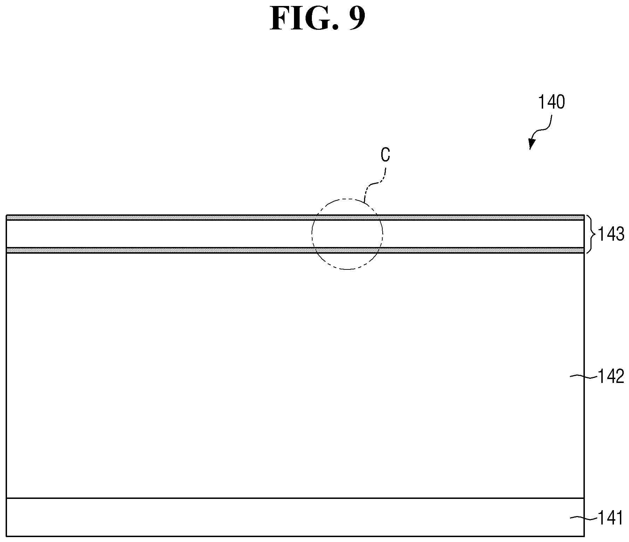

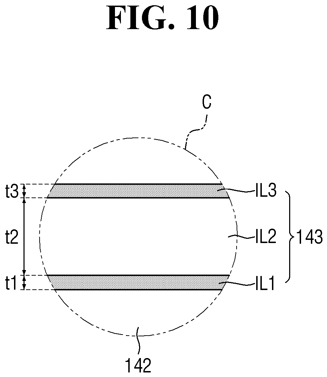

FIG. 9 is a schematic view of the encapsulation layer 140 of the display device 10 according to an embodiment. FIG. 10 is an enlarged view of part C of FIG. 9.

Referring to FIGS. 9 and 10, in an embodiment of the display device 10, the first inorganic encapsulation layer 141 and/or the second inorganic encapsulation layer 143 of the encapsulation layer 140 may have a structure in which one or more inorganic insulating layers are stacked. A plurality of inorganic insulating layers of the first inorganic encapsulation layer 141 and the second inorganic encapsulation layer 143 may be formed through different processes. Even if the first inorganic encapsulation layer 141 and/or the second inorganic encapsulation layer 143 has a structure in which a plurality of layers are stacked, the first inorganic encapsulation layer 141 and/or the second inorganic encapsulation layer 143 may be relatively thin. In an embodiment of the display device 10, the first inorganic encapsulation layer 141 and/or the second inorganic encapsulation layer 143 including a plurality of inorganic insulating layers may have a thin thickness and serve to encapsulate the display panel 100.

The first inorganic encapsulation layer 141 and/or the second inorganic encapsulation layer 143 may include a first inorganic layer IL1, a second inorganic layer IL2, and a third inorganic layer IL3. The first inorganic encapsulation layer 141 and/or the second inorganic encapsulation layer 143 may have a structure in which the first inorganic layer IL1, the second inorganic layer IL2, and the third inorganic layer IL3 are sequentially stacked on each other. In an embodiment in which the first inorganic layer IL1, the second inorganic layer IL2, and the third inorganic layer IL3 have different materials or physical properties from each other, the first inorganic encapsulation layer 141 and/or the second inorganic encapsulation layer 143 may have a structure in which inorganic insulating layers having different properties are stacked on each other. However, the disclosure is not limited thereto. In an embodiment in which the first inorganic layer IL1 and the third inorganic layer IL3 have a same material and physical properties as each other, the first inorganic encapsulation layer 141 and/or the second inorganic encapsulation layer 143 may have a structure in which inorganic insulating layers having different properties are alternately and repeatedly stacked.

According to an embodiment, the first inorganic layer IL1, the second inorganic layer IL2, and the third inorganic layer IL3 may include a same material as each other, but the second inorganic layer IL2 may be formed through a different fabrication process from the first inorganic layer IL1 and the third inorganic layer IL3. Accordingly, the second inorganic layer IL2 may have different physical properties from the first inorganic layer IL1 and the third inorganic layer IL3, and the first inorganic layer IL1 and the third inorganic layer IL3 may have a same physical properties as each other.

In an embodiment, for example, each of the first inorganic layer IL1, the second inorganic layer IL2, and the third inorganic layer IL3 may include silicon nitride (SiNₓ). The first inorganic layer IL1 and the third inorganic layer IL3 may be formed through a plasma enhanced chemical vapor deposition (PECVD) process or a plasma enhanced atomic layer deposition (PEALD) process, and the second inorganic layer IL2 may be formed through a PECVD process. A deposition rate may be faster or higher in the formation process of the second inorganic layer IL2 than in the formation process of the first inorganic layer IL1 and the third inorganic layer IL3. The second inorganic layer IL2 may have different physical properties from the first inorganic layer IL1 and the third inorganic layer IL3 depending on process conditions of the deposition process.

In an embodiment, for example, a thickness t2 of the second inorganic layer IL2 may be greater than thicknesses t1 and t3 of the first inorganic layer IL1 and the third inorganic layer IL3. In an embodiment, the thickness t1 of the first inorganic layer IL1 and the thickness t3 of the third inorganic layer IL3 may each be about 50 angstrom (Å) or less. In such an embodiment, the thickness t2 of the second inorganic layer IL2 may be about 50 Å or greater, and the ratio (t1/t2) of the thickness t1 of the first inorganic layer IL1 to the thickness t2 of the second inorganic layer IL2 may be 0.03 or less (e.g. 0.03:1 or less). In addition, the total thickness (t1+t2+t3) of the first inorganic encapsulation layer 141 and/or the second inorganic encapsulation layer 143 may be about 0.4 micrometer (µm) or less. Since the first inorganic layer IL1 and the third inorganic layer IL3 are formed thinner than the second inorganic layer IL2, the total thickness of the first inorganic encapsulation layer 141 and/or the second inorganic encapsulation layer 143 and the total thickness of the encapsulation layer 140 may be reduced. Furthermore, the total thickness of the first inorganic layer II,1, the second inorganic layer IL2 and the third inorganic layer IL3 and the thickness ratio of the layers having different thicknesses may be adjusted within the above range. Therefore, even if the first inorganic encapsulation layer 141 and/or the second inorganic encapsulation layer 143 have a thin thickness, the first inorganic encapsulation layer 141 and/or the second inorganic encapsulation layer 143 can have sufficient encapsulation properties.

The first inorganic layer IL1 and the third inorganic layer IL3 may be formed through a slower deposition process than the second inorganic layer IL2. Accordingly, the first inorganic layer IL1 and the third inorganic layer IL3 may have a greater layer density than the second inorganic layer IL2. In an embodiment, for example, the layer density of the second inorganic layer IL2 may be in a range of about 1.7 gram per cubic centimeter (g/cm³) to about 2.10 g/cm³, and the layer density of each of the first inorganic layer IL1 and the third inorganic layer IL3 may be about 2.05 g/cm³ or greater and may be greater than that of the second inorganic layer IL2. A refractive index of the second inorganic layer IL2 may be in a range of about 1.75 to about 1.90, and a refractive index of each of the first inorganic layer IL1 and the third inorganic layer IL3 may be about 1.85 or greater and may be greater than that of the second inorganic layer IL2. The values of refractive index recited herein may be determined with respect to 550 nm using an Ellipsometer apparatus in the air. Since the first inorganic layer IL1 and the third inorganic layer IL3 formed through a slow deposition process may have dense layer properties, the first inorganic layer IL1 and the third inorganic layer IL3 may have high encapsulation properties. However, the first inorganic layer IL1 and the third inorganic layer IL3 may be formed to be thinner than the second inorganic layer IL2 in consideration of the fabrication process yield.

In addition, the second inorganic layer IL2 may have a relatively low layer density, but a layer density of at least about 1.7 g/cm³ or greater. Furthermore, since the ratio of the thickness t1 of the high-density first inorganic layer IL1 to the thickness t2 of the low-density second inorganic layer IL2 is adjusted to be 0.03 or less, the second inorganic layer IL2 may have high encapsulation properties, like the first inorganic layer IL1 and the third inorganic layer IL3. In particular, side surfaces of the second inorganic layer IL2 may be exposed in the inorganic bonding area IEA of the outer portion of the display panel 100. However, since the second inorganic layer IL2 has a sufficient layer density, the second inorganic layer IL2 can effectively prevent moisture penetration from the outside.

In an embodiment, the layer densities of the first through third inorganic layers IL1 through IL3 may be measured using an X-ray reflectometer (XRR) (Bruker's D8 ADVANCE Plus) device. In some embodiments, the layer densities of the first inorganic layer IL1 and the third inorganic layer IL3 measured using the XRR device may be in a range of about 2.14 g/cm³ to about 2.70 g/cm³, and the layer density of the second inorganic layer IL2 measured using the XRR device may be in a range of about 1.90 g/cm³ to about 2.04 g/cm³. However, the disclosure is not limited thereto.

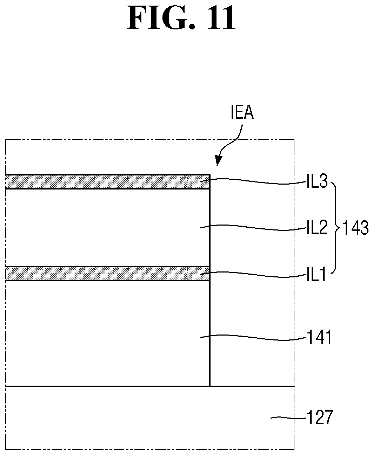

FIG. 11 is an enlarged view of the inorganic bonding area IEA in the outer portion of the display panel 100 according to an embodiment.

Referring to FIG. 11, in an embodiment of the display panel 100, the first inorganic encapsulation layer 141 and the second inorganic encapsulation layer 143 may contact each other in the inorganic bonding area IEA. In an embodiment in which the second inorganic encapsulation layer 143 includes a plurality of inorganic layers IL1 through IL3, the first inorganic layer IL1 of the second inorganic encapsulation layer 143 may directly contact an upper surface of the first inorganic encapsulation layer 141. Side surfaces of each of the first inorganic encapsulation layer 141 and the second inorganic encapsulation layer 143 may be exposed in the outer portion of the display panel 100. Side surfaces of the second inorganic layer IL2 having a relatively low layer density among the inorganic layers II,1 through IL3 of the second inorganic encapsulation layer 143 may also be exposed.

In an embodiment, a water vapor transmission rate (WVTR) of the second inorganic layer IL2 may be about 3×10⁻⁴ gram per square meter per day (g/m²day) or less, and a total WVTR of the inorganic encapsulation layer 141 or 143 including the first inorganic layer IL1, the second inorganic layer IL2 and the third inorganic layer IL3 may be about 5×10⁻⁵ g/m²day or less. The WVTR may be measured according to ASTM F 1249. The WVTR may be measured using Aquatran apparatus (Mocon company) at 37.8 °C (temperature) and 90% RH (humidity) Since the first inorganic encapsulation layer 141 and/or the second inorganic encapsulation layer 143 have a structure in which a plurality of inorganic layers IL1 through IL3 are stacked, the first inorganic encapsulation layer 141 and/or the second inorganic encapsulation layer 143 can have high encapsulation properties while the total thickness thereof is reduced or substantially thin. In particular, the relatively thick second inorganic layer IL2 may have a WVTR of about 3×10⁻⁴ g/m²day or less and may have sufficient encapsulation properties even if its side surfaces are exposed in the outer portion of the display panel 100.

According to an embodiment, in an embodiment of the display device 10, the first inorganic encapsulation layer 141 and/or the second inorganic encapsulation layer 143 of the encapsulation layer 140 may include a plurality of inorganic layers IL1 through IL3. Therefore, the first inorganic encapsulation layer 141 and/or the second inorganic encapsulation layer 143 may have a thin thickness but sufficient encapsulation properties. Accordingly, even if the display device 10 is reduced in size, damage due to moisture penetration from the outside can be effectively prevented. In an embodiment, where the display device 10 has foldable characteristics, its folding and bending characteristics may be improved because the thickness of the encapsulation layer 140 is reduced.

An embodiment of a method of fabricating a display device 10 will now be described with reference to other drawings.

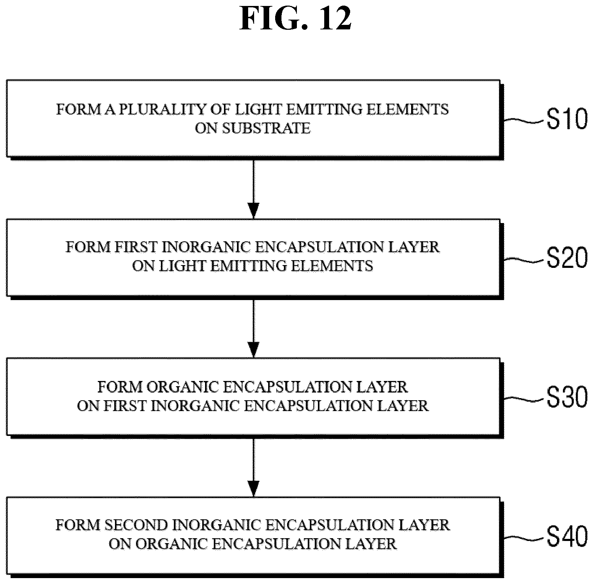

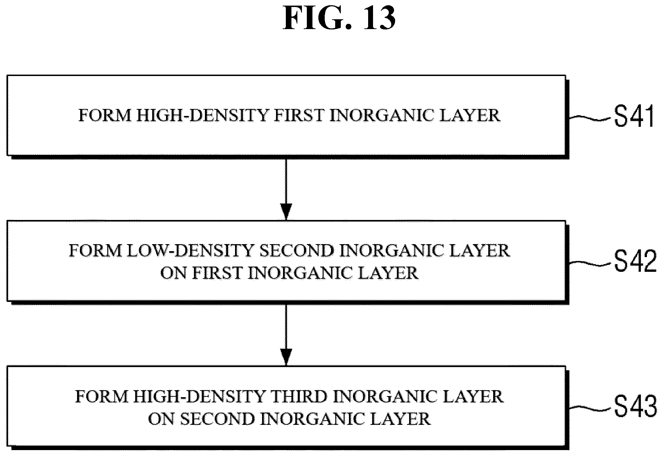

FIG. 12 is a flowchart illustrating a method of fabricating a display device according to an embodiment. FIG. 13 is a flowchart illustrating, in detail, a process of forming a second inorganic encapsulation layer in FIG. 12.

Referring to FIGS. 12 and 13, the method of fabricating the display device 10 according to an embodiment may include forming a plurality of light emitting elements EL on a substrate (operation S10), forming a first inorganic encapsulation layer 141 on the light emitting elements EL (operation S20), forming an organic encapsulation layer 142 on the first inorganic encapsulation layer 141 (operation S30), and forming a second inorganic encapsulation layer 143 on the organic encapsulation layer 142 (operation S40). The forming of the second inorganic encapsulation layer 143 (operation S40) may include forming a high-density first inorganic layer IL1 (operation S41), forming a low-density second inorganic layer IL2 on the first inorganic layer IL1 (operation S42), and forming a high-density third inorganic layer IL3 on the second inorganic layer IL2 (operation S43). In an embodiment of the method of fabricating the display device 10, the first inorganic encapsulation layer 141 and/or the second inorganic encapsulation layer 143 may include the inorganic layers IL1 through IL3 formed through different deposition processes.

Although FIGS. 12 and 13 and subsequent drawings illustrate an embodiment in which the second inorganic encapsulation layer 143 includes a plurality of inorganic layers IL1 through IL3, the disclosure is not limited thereto. The first inorganic encapsulation layer 141 may also include a plurality of inorganic layers IL1 through IL3. In this case, the forming of the first inorganic encapsulation layer 141 on the light emitting elements EL (operation S20) may be performed through a plurality of deposition processes.

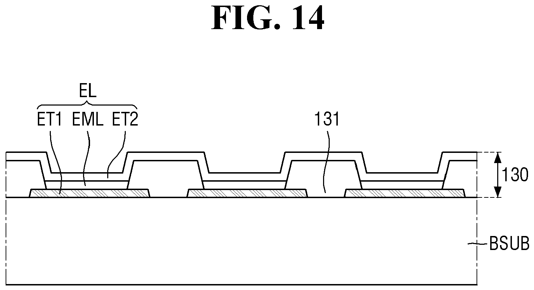

FIGS. 14 through 19 are views sequentially illustrating a process of fabricating a display device according to an embodiment.

Referring to FIG. 14, in an embodiment of the method of fabricating the display device 10, a plurality of light emitting elements EL are formed on a substrate BSUB (operation S10) to form a light emitting element layer 130. A pixel defining layer 131 may be formed on the substrate BSUB, and the light emitting elements EL may be formed in openings of the pixel defining layer 131. The structures of the pixel defining layer 131 and the light emitting elements EL are the same as those described above. Each of the pixel defining layer 131 and the light emitting elements EL may be formed through a typical patterning process or a deposition process.

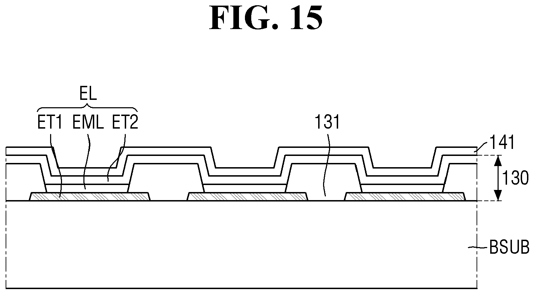

Referring to FIG. 15, a first inorganic encapsulation layer 141 is formed on the light emitting elements EL (operation S20). The first inorganic encapsulation layer 141 may be composed of one inorganic insulating layer, but the disclosure is not limited thereto. Like a second inorganic encapsulation layer 143 to be described later, the first inorganic encapsulation layer 141 may also be composed of or defined by a plurality of inorganic layers IL1 through IL3.

The first inorganic encapsulation layer 141 may include silicon nitride (SiNₓ), like the inorganic layers IL1 through IL3, and may have a thickness similar to that of the second inorganic encapsulation layer 143. In an embodiment, the first inorganic encapsulation layer 141 may be formed through a PECVD process using a gaseous precursor or a liquid precursor. However, the disclosure is not limited thereto. In an embodiment in which the first inorganic encapsulation layer 141 includes a plurality of inorganic layers IL1 through IL3, each of the inorganic layers IL1 through IL3 may be formed through a process to be described later.

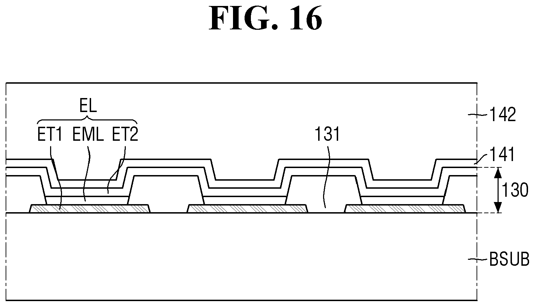

Referring to FIG. 16, an organic encapsulation layer 142 is formed on the first inorganic encapsulation layer 141 (operation S30). The organic encapsulation layer 142 may include an organic insulating material. The process of forming the organic encapsulation layer 142 is not particularly limited. In an embodiment, for example, the organic encapsulation layer 142 may be formed through a chemical vapor deposition (CVD) method or an inkjet printing process.

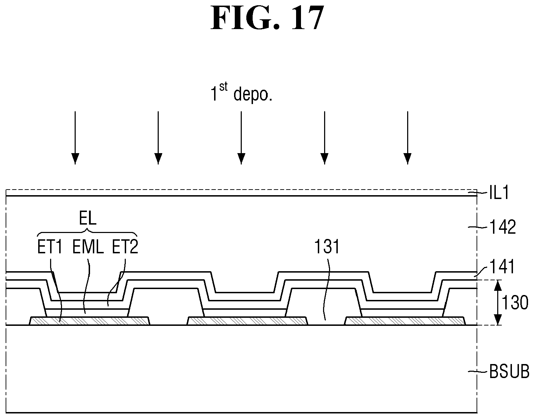

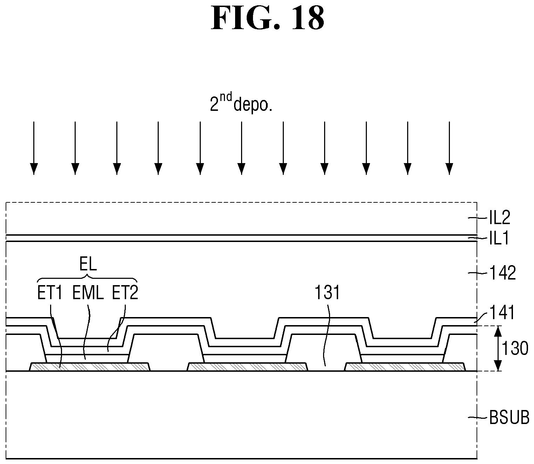

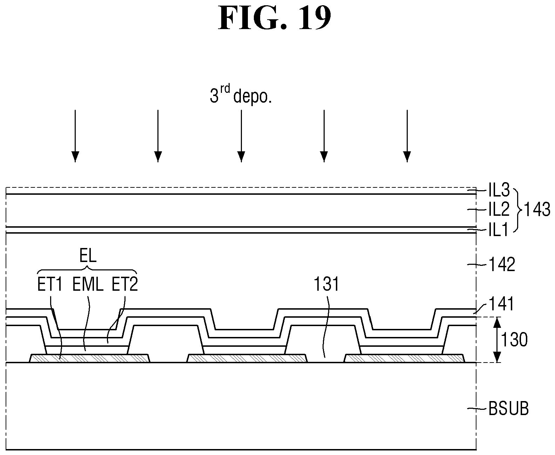

Referring to FIGS. 17 through 19, the second inorganic encapsulation layer 143 is formed on the organic encapsulation layer 142 (operation S40). The forming of the second inorganic encapsulation layer 143 may include forming a high-density first inorganic layer IL1 illustrated in FIG. 17 (operation S41), forming a low-density second inorganic layer IL2 on the first inorganic layer IL1 illustrated in FIG. 18 (operation S42), and forming a high-density third inorganic layer IL3 on the second inorganic layer IL2 illustrated in FIG. 19 (operation S43).

In an embodiment, the forming of the first inorganic layer IL1 (operation S41) and the forming of the third inorganic layer IL3 (operation S43) may be performed by a PEALD or PECVD process using a liquid precursor, and the forming of the second inorganic layer IL2 (operation S42) may be performed by a PECVD process using a gaseous precursor or a liquid precursor. The forming of the first inorganic layer IL1 (operation S41) and the forming of the third inorganic layer IL3 (operation S43) may be slow deposition processes and may have a deposition rate of about 300 angstrom per minute (Å/min) or less. The forming of the second inorganic layer IL2 (operation S42) may be a fast deposition process and may have a deposition rate of about 300 Å/min or greater. The first inorganic layer IL1 and the third inorganic layer IL3 may have a high layer density due to their slow deposition rate, and the second inorganic layer IL2 may have a low layer density due to its fast deposition rate. However, the first inorganic layer IL1 and the third inorganic layer IL3 may be thin because the first inorganic layer IL1 and the third inorganic layer IL3 are formed in a short time in consideration of the fabrication process yield, and the second inorganic layer IL2 may be relatively thick.

In an embodiment of the fabrication process of the display device 10, the forming of the high-density first inorganic layer IL1 (operation S41) and the forming of the high-density third inorganic layer IL3 (operation S43) may use a liquid precursor for a PEALD process. In an embodiment where the first inorganic layer IL1 and the third inorganic layer IL3 are formed through a PEALD process using a liquid precursor, a higher refractive index and a lower WVTR can be achieved than when a gaseous precursor is used. In addition, the second inorganic encapsulation layer 143 including the second inorganic layer IL2 formed by PECVD in addition to the first inorganic layer IL1 and the third inorganic layer IL3 may also have high encapsulation properties.

In an embodiment, the inorganic layers IL1 through IL3 may include silicon nitride (SiNₓ), and the liquid precursor used in a deposition process for forming the inorganic layers IL1 through IL3 may be an aminosilane-based compound having a Si-N bond as a core structure. In an embodiment, for example, the liquid precursor used in the process of forming the inorganic layers IL1 through IL3 may include or be composed of at least one selected from, but not limited to, cyclosilizane, trisilyamine, bis(diethylamino)silane, bis(t-butylamino)silane, tris(dimethylamino)silane, tris(isopropylamino)silane, tetrakis(dimethylamino)silane, tri(isopropyl)cyclotrisilazane, and tetramethyldisilazane.

In an embodiment of the fabrication process of the display device 10, the first inorganic encapsulation layer 141 and/or the second inorganic encapsulation layer 143 of the encapsulation layer 140 may include a plurality of inorganic layers II,1 through IL3 formed through different deposition processes. Therefore, the first inorganic encapsulation layer 141 and/or the second inorganic encapsulation layer 143 may have a thin thickness and excellent encapsulation properties. An embodiment in which the second inorganic encapsulation layer 143 of the encapsulation layer 140 includes a plurality of inorganic layers IL1 through IL3 has been described above. However, the disclosure is not limited thereto, and the first inorganic encapsulation layer 141 may also include a plurality of inorganic layers IL1 through IL3.

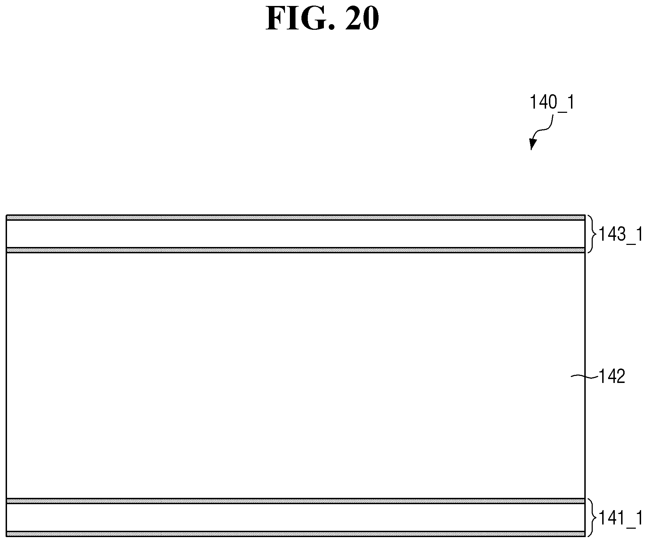

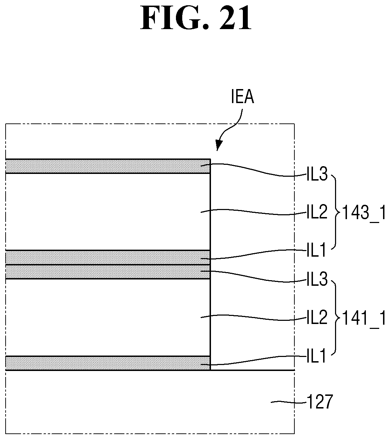

FIG. 20 illustrates an encapsulation layer 140_1 of a display device 10 according to an embodiment. FIG. 21 is an enlarged view of an inorganic bonding area IEA in an outer portion of the display device 10 of FIG. 20.

Referring to FIGS. 20 and 21, in the display device 10 according to an embodiment, a first inorganic encapsulation layer 141_1 and a second inorganic encapsulation layer 143_1 of the encapsulation layer 140_1 may each have a structure in which a plurality of inorganic insulating layers are stacked on each other. Each of the first inorganic encapsulation layer 141_1 and the second inorganic encapsulation layer 143_1 may include a first inorganic layer IL1, a second inorganic layer IL2, and a third inorganic layer IL3. The inorganic layers II,1 through IL3 of each of the first inorganic encapsulation layer 141_1 and the second inorganic encapsulation layer 143_1 are the same as those described above. In an embodiment, for example, the inorganic layers IL1 through IL3 of each of the first inorganic encapsulation layer 141_1 and the second inorganic encapsulation layer 143_1 may have different thicknesses and different layer densities from each other.

In addition, the formation process of the inorganic layers II,1 through IL3 of the first inorganic encapsulation layer 141_1 may be the same as the formation process of the second inorganic encapsulation layer 143_1 described above with reference to FIGS. 17 through 19.

In an embodiment of the display device 10, since each of the first inorganic encapsulation layer 141_1 and the second inorganic encapsulation layer 143_1 of the encapsulation layer 140_1 includes the inorganic layers II,1 through IL3 having different physical properties from each other, the encapsulation layer 140_1 may have high encapsulation properties while the total thickness thereof is reduced or substantially thin. Accordingly, in an embodiment where the display device 10 has foldable characteristics or is reduced in size, the encapsulation layer 140_1 can have characteristics suitable for the display device 10.

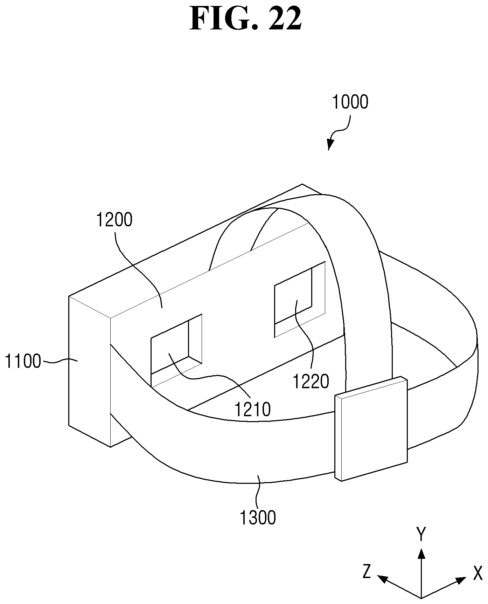

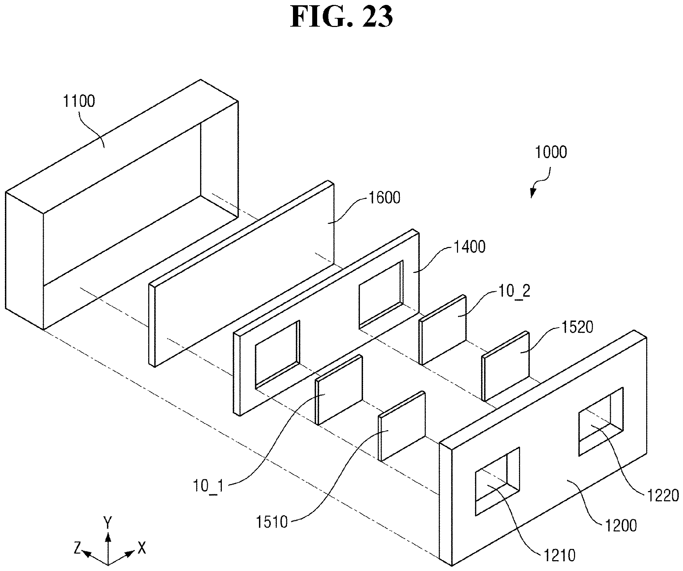

FIG. 22 is a perspective view of a head mounted display device 1000 according to an embodiment. FIG. 23 is an exploded perspective view of an example of the head mounted display device 1000 of FIG. 22.

Referring to FIGS. 22 and 23, the head mounted display device 1000 according to an embodiment includes a first display device 10_1, a second display device 10_2, a display device housing 1100, a housing cover 1200, a first eyepiece 1210, a second eyepiece 1220, a head mounted band 1300, a middle frame 1400, a first optical member 1510, a second optical member 1520, a control circuit board 1600, and a connector.

The first display device 10_1 provides an image to a user's left eye, and the second display device 10_2 provides an image to the user's right eye. Each of the first display device 10_1 and the second display device 10_2 is substantially the same as the display device 10 described with reference to FIG. 1. Therefore, any repetitive detailed description of the first display device 10_1 and the second display device 10_2 will be omitted.

The first optical member 1510 may be disposed between the first display device 10_1 and the first eyepiece 1210. The second optical member 1520 may be disposed between the second display device 10_2 and the second eyepiece 1220. Each of the first optical member 1510 and the second optical member 1520 may include at least one convex lens.

The middle frame 1400 may be disposed between the first display device 10_1 and the control circuit board 1600 and may be disposed between the second display device 10_2 and the control circuit board 1600. The middle frame 1400 supports and fixes the first display device 10_1, the second display device 10_2, and the control circuit board 1600.

The control circuit board 1600 may be disposed between the middle frame 1400 and the display device housing 1100. The control circuit board 1600 may be connected to the first display device 10_1 and the second display device 10_2 through the connector. The control circuit board 1600 may convert an image source received from the outside into digital video data and transmit the digital video data to the first display device 10_1 and the second display device 10_2 through the connector.

The control circuit board 1600 may transmit the digital video data corresponding to a left-eye image optimized for a user's left eye to the first display device 10_1 and transmit the digital video data corresponding to a right-eye image optimized for the user's right eye to the second display device 10_2. Alternatively, the control circuit board 1600 may transmit the same digital video data to the first display device 10_1 and the second display device 10_2.

The display device housing 1100 houses the first display device 10_1, the second display device 10_2, the middle frame 1400, the first optical member 1510, the second optical member 1520, the control circuit board 1600, and the connector. The housing cover 1200 is placed to cover an open surface of the display device housing 1100. The housing cover 1200 may include the first eyepiece 1210 on which a user's left eye is placed and the second eyepiece 1220 on which the user's right eye is placed. In an embodiment, the first eyepiece 1210 and the second eyepiece 1220 may be disposed separately as shown in FIGS. 22 and 23, but the disclosure is not limited thereto. In an embodiment, the first eyepiece 1210 and the second eyepiece 1220 may also be combined into one.

The first eyepiece 1210 may be aligned with the first display device 10_1 and the first optical member 1510, and the second eyepiece 1220 may be aligned with the second display device 10_2 and the second optical member 1520. Therefore, a user can view an image of the first display device 10_1, which is enlarged as a virtual image by the first optical member 1510, through the first eyepiece 1210 and can view an image of the second display device 10_2, which is enlarged as a virtual image by the second optical member 1520, through the second eyepiece 1220.

The head mounted band 1300 fixes the display device housing 1100 to a user's head so that the first eyepiece 1210 and the second eyepiece 1220 of the housing cover 1200 are kept placed on the user's left and right eyes, respectively. In an embodiment where the display device housing 1200 is desired to be implemented to be lightweight and small, the head mounted display device 1000 may include an eyeglass frame as illustrated in FIG. 23 instead of the head mounted band 1300.

In addition, the head mounted display device 1000 may further include a battery for supplying power, an external memory slot for accommodating an external memory, and an external connection port and a wireless communication module for receiving an image source. The external connection port may be a universe serial bus (USB) terminal, a display port, or a high-definition multimedia interface (HDMI) terminal, and the wireless communication module may be a 5G communication module, a 4G communication module, a Wi-Fi module, or a Bluetooth module.

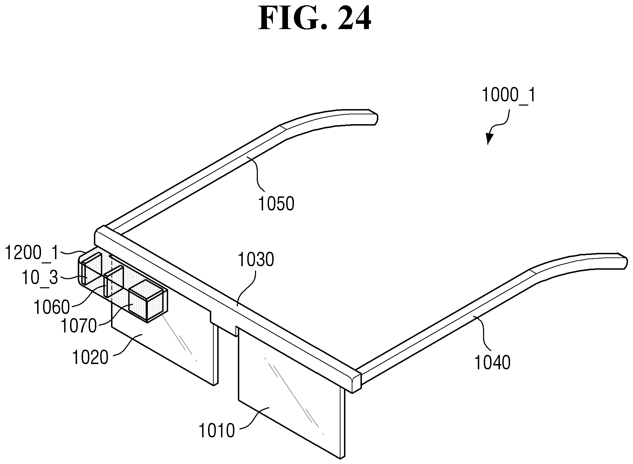

FIG. 24 is a perspective view of a head mounted display device 1000_1 according to an embodiment.

Referring to FIG. 24, the head mounted display device 1000_1 according to an embodiment may be a display device in the form of glasses in which a display device housing 1200_1 is implemented to be lightweight and small. The head mounted display device 1000_1 according to an embodiment may include a display device 10_3, a left-eye lens 1010, a right-eye lens 1020, a support frame 1030, eyeglass frame legs 1040 and 1050, an optical member 1060, an optical path conversion member 1070, and the display device housing 1200_1.

The display device housing 1200_1 may include the display device 10_3, the optical member 1060, and the optical path conversion member 1070. An image displayed on the display device 10_3 may be enlarged by the optical member 1060, may have its optical path converted by the optical path conversion member 1070, and then may be provided to a user's right eye through the right-eye lens 1020. Accordingly, the user can view, through the right eye, an augmented reality image into which a virtual image displayed on the display device 10_3 and a real image viewed through the right-eye lens 1020 are combined.

In an embodiment, the display device housing 1200_1 may be disposed at a right end of the support frame 1030 as shown in FIG. 24, but the disclosure is not limited thereto. In an embodiment, for example, the display device housing 1200_1 may also be disposed at a left end of the support frame 1030. In such an embodiment, an image of the display device 10_3 may be provided to a user's left eye. Alternatively, the display device housing 1200_1 may be disposed at both the left and right ends of the support frame 1030. In such an embodiment, the user can view an image displayed on the display device 10_3 through both the left and right eyes.

In a display device according to an embodiment, an inorganic encapsulation layer of an encapsulation layer includes a plurality of inorganic layers formed through different deposition processes, respectively. Therefore, the inorganic encapsulation layer can have high encapsulation properties while having a thin thickness.

In an embodiment, where the display device has flexible characteristics, damage to the encapsulation layer during folding or bending can be effectively prevented because the thickness of the encapsulation layer is reduced or substantially thin.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device comprising:
a substrate on which a display area and a non-display area surrounding the display area are defined;
a light emitting element layer disposed on the substrate and comprising a plurality of light emitting elements disposed in the display area; and
an encapsulation layer comprising a first inorganic encapsulation layer disposed on the light emitting element layer, an organic encapsulation layer disposed on the first inorganic encapsulation layer, and a second inorganic encapsulation layer disposed on the organic encapsulation layer,
wherein at least one selected from the first inorganic encapsulation layer and the second inorganic encapsulation layer comprises a first inorganic layer, a second inorganic layer disposed on the first inorganic layer and a third inorganic layer disposed on the second inorganic layer,
a thickness of each of the first inorganic layer and the third inorganic layer is less than a thickness of the second inorganic layer,
the thickness of each of the first inorganic layer and the third inorganic layer is about 50 Å or less, and
a ratio of the thickness of the first inorganic layer to the thickness of the second inorganic layer is about 0.03 or less.

2. The display device of claim 1, wherein a sum of thicknesses of the first inorganic layer, the second inorganic layer, and the third inorganic layer is about 0.4 µm or less.

3. The display device of claim 1 or claim 2, wherein a layer density of the second inorganic layer is in a range of about 1.7 g/cm³ to about 2.10 g/cm³,
a layer density of each of the first inorganic layer and the third inorganic layer is about 2.05 g/cm³ or greater, and
the layer density of each of the first inorganic layer and the third inorganic layer is greater than the layer density of the second inorganic layer.

4. The display device of any one of claims 1 to 3, wherein a refractive index of the second inorganic layer is in a range of about 1.75 to about 1.90,
a refractive index of each of the first inorganic layer and the third inorganic layer is about 1.85 or greater, and
the refractive index of each of the first inorganic layer and the third inorganic layer is greater than the refractive index of the second inorganic layer.

5. The display device of any one of claims 1 to 4, wherein:
(i) each of the first inorganic layer, the second inorganic layer, and the third inorganic layer comprises silicon nitride (SiNₓ); and/or
(ii) each of the first inorganic encapsulation layer and the second inorganic encapsulation layer comprises the first inorganic layer, the second inorganic layer, and the third inorganic layer.

6. The display device of any one of claims 1 to 5, wherein the first inorganic encapsulation layer and the second inorganic encapsulation layer comprising the first inorganic layer, the second inorganic layer and the third inorganic layer have a water vapor transmission rate of about 5×10⁻⁵ g/m²day or less, optionally wherein the second inorganic layer has a water vapor transmission rate of about 3×10⁻⁴ g/m²day or less.

7. The display device of any one of claims 1 to 6, further comprising a first dam disposed in the non-display area and surrounding the display area and a second dam surrounding the first dam,
wherein the organic encapsulation layer is disposed in the display area and the non-display area inside the second dam.

8. The display device of claim 7, wherein the first inorganic encapsulation layer and the second inorganic encapsulation layer directly contact each other in the non-display area outside the second dam, optionally wherein side surfaces of the second inorganic layer are exposed in the non-display area.

9. The display device of any one of claims 1 to 8, further comprising a circuit layer disposed between the substrate and the light emitting element layer,
wherein the circuit layer comprises a first semiconductor layer, a first insulating layer, a first conductive layer, a second insulating layer, a second conductive layer, a third insulating layer, a second semiconductor layer, a fourth insulating layer, a third conductive layer, a fifth insulating layer, and a fourth conductive layer sequentially disposed on the substrate.

10. A method of fabricating a display device, the method comprising:
forming a light emitting element layer, which comprises a plurality of light emitting elements, on a substrate;
forming a first inorganic encapsulation layer on the light emitting element layer and forming an organic encapsulation layer on the first inorganic encapsulation layer; and
forming a second inorganic encapsulation layer on the organic encapsulation layer,
wherein the forming of the second inorganic encapsulation layer comprises:
forming a first inorganic layer having a high-density on the organic encapsulation layer;
forming a second inorganic layer having a low-density on the first inorganic layer; and
forming a third inorganic layer having a high-density on the second inorganic layer,
wherein a deposition rate in the forming of the second inorganic layer is higher than a deposition rate in the forming of the first inorganic layer and the forming of the third inorganic layer.

11. The method of claim 10, wherein:
(i) the deposition rate in the forming of the second inorganic layer is about 300 Å/min or greater, and
the deposition rate in each of the forming of the first inorganic layer and the forming of the third inorganic layer is about 300 Å/min or less; and/or
(ii) a thickness of each of the first inorganic layer and the third inorganic layer is less than a thickness of the second inorganic layer,
the thickness of each of the first inorganic layer and the third inorganic layer is about 50 Å or less, and
a ratio of the thickness of the first inorganic layer to the thickness of the second inorganic layer is about 0.03 or less.

12. The method of claim 10 or claim 11, wherein a layer density of the second inorganic layer is in a range of about 1.7 g/cm³ to about 2.10 g/cm³,
a layer density of each of the first inorganic layer and the third inorganic layer is about 2.05 g/cm³ or greater and is greater than the layer density of the second inorganic layer,
a refractive index of the second inorganic layer is in a range of about 1.75 to about 1.90,
a refractive index of each of the first inorganic layer and the third inorganic layer is about 1.85 or greater, and
the refractive index of each of the first inorganic layer and the third inorganic layer is greater than the refractive index of the second inorganic layer.

13. The method of any one of claims 10 to 12, wherein the forming of the first inorganic layer and the forming of the third inorganic layer are each performed through a plasma enhanced atomic layer deposition process or a plasma enhanced chemical vapor deposition process, and
the forming of the second inorganic layer is performed through a plasma enhanced chemical vapor deposition process.

14. The method of claim 13, wherein the forming of the first inorganic layer and the forming of the third inorganic layer are performed using a liquid precursor which comprises a Si-N bond, optionally wherein the liquid precursor includes at least one selected from cyclosilizane, trisilyamine, bis(diethylamino)silane, bis(t-butylamino)silane, tris(dimethylamino)silane, tris(isopropylamino)silane, tetrakis(dimethylamino)silane, tri(isopropyl)cyclotrisilazane, and tetramethyldisilazane.

15. The method of any one of claims 10 to 14, wherein the second inorganic encapsulation layer comprising the first inorganic layer, the second inorganic layer and the third inorganic layer has a water vapor transmission rate of 5×10⁻⁵ g/m²day or less, and
the second inorganic layer has a water vapor transmission rate of 3×10⁻⁴ g/m²day or less.
